# EUROPEAN PATENT SPECIFICATION

(11) **EP 4 445 365 B1**
(45) Date of publication and mention of the grant of the patent: **27.05.2026**
(21) Application number: 22769193.8
(22) Date of filing: 24.08.2022
(51) Int. Cl.: G10L 19/16, H03G 7/00, G10L 19/008, H04S 7/00

(54) **METHOD AND APPARATUS FOR PROCESSING OF AUDIO DATA**
VERFAHREN UND VORRICHTUNG ZUR VERARBEITUNG VON AUDIODATEN
PROCÉDÉ ET APPAREIL POUR TRAITER DES DONNÉES AUDIO

(30) Priority: 07.12.2021 US 202163287029 P; 16.12.2021 US 202163290493 P
(43) Date of publication of application: 16.10.2024
(73) Proprietor: Dolby International AB, Dublin, D02 VK60 (IE)
(72) Inventor: FERSCH, Christof, San Francisco, California 94103 (US)
(74) Representative: Dolby International AB Patent Group Europe
(86) International application number: PCT/EP2022/073628
(87) International publication number: WO 2023/104360

(56) References cited:
- WO-A1-2015/038522
- US-A1- 2017 032 793

## Description

### TECHNOLOGY

The present disclosure relates generally to a method of metadata-based dynamic processing of audio data for playback and, in particular, to determining and applying one or more processing parameters to the audio data for dynamic loudness adjustment and/or dynamic range compression. The present disclosure further relates to a method of encoding audio data and metadata for dynamic loudness adjustment and/or dynamic range compression into a bitstream. The present disclosure yet further relates to a respective decoder and encoder as well as to a respective system and computer program products. The present disclosure further relates to a method of processing audio data for playback, a decoder for processing audio data for playback, and respective computer program products.

While some embodiments will be described herein with particular reference to that disclosure, it will be appreciated that the present disclosure is not limited to such a field of use and is applicable in broader contexts.

### BACKGROUND

Any discussion of the background art throughout the disclosure should in no way be considered as an admission that such art is widely known or forms part of common general knowledge in the field.

In playing back audio content, loudness is the individual experience of sound pressure. In cinematic or television content, the loudness of dialogue in a program has been found to be the most crucial parameter determining the perception of program loudness by a listener.

To determine the average loudness of a program, either of the full program or dialogue only, analysis of the entire program has to be performed. The average loudness is typically required for loudness compliance (for example, the CALM act in the US), and is also used for aligning dynamic range control (DRC) parameters. The dynamic range of a program is the difference between its quietest and loudest sounds. The dynamic range of a program depends on its content, for example, an action movie may have a different and wider dynamic range than a documentary, and reflects a creator's intent. However, capabilities of devices to play back audio content in the original dynamic range vary strongly. Besides loudness management, dynamic range control is thus a further key factor in providing optimal listening experience.

To perform loudness management and dynamic range control, the entire audio program or an audio program segment has to be analyzed and the resulting loudness and DRC parameters can be delivered along with audio data or encoded audio data to be applied in a decoder or playback device.

When analysis of an entire audio program or an audio program segment prior to encoding is not available, for example in real-time (dynamic) encoding, loudness processing or levelling is used to ensure loudness compliance and, if applicable, potential dynamic range constraints depending on playback requirements. This approach delivers processed audio that is "optimized" for a single playback environment.

There is thus an existing need for metadata-based processes that deliver "original" unprocessed audio with accompanying metadata allowing the playback device to use the metadata to modify the audio dynamically depending on device constraints or user requirements.

US 2017/032793 A1 relates to an audio encoder which encodes a digital audio recording having a number of audio channels or audio objects. A Dynamic Range Control (DRC) processor produces a sequence of encoder DRC gain values, by applying a selected one of a number of DRC characteristics to a group of one or more of the audio channels or audio objects. The encoder DRC gain values are to be applied to adjust the group of audio channels or audio objects, upon decoding them from the encoded digital audio recording. A bitstream multiplexer combines a) the encoded digital audio recording with b) the sequence of encoder DRC gain values, an indication of the selected DRC characteristic, and an indication of an alternate DRC characteristic, the latter as metadata associated with the encoded digital audio recording. Other embodiments are also described including a system for decoding the encoded audio recording and performing DRC adjustment upon it.

### SUMMARY

In accordance with a first aspect of the present disclosure there is provided a method of metadata-based dynamic processing of audio data for playback. The method may include receiving, by a decoder, a bitstream including audio data and metadata for dynamic loudness. The method may further include decoding, by the decoder, the audio data and the metadata to obtain decoded audio data and the metadata. The method may further include determining, by the decoder, from the metadata, one or more processing parameters for dynamic loudness adjustment based on a playback condition. The method may further include applying the determined one or more processing parameters to the decoded audio data to obtain processed audio data. And the method may include outputting the processed audio data for playback.

The metadata for dynamic loudness adjustment may include a plurality of sets of metadata, with each set corresponding to a respective (e.g., different) playback condition. Then, determining the one or more processing parameters for dynamic loudness adjustment from the metadata based on a (specific) playback condition may include selecting, in response to playback condition information provided to the decoder, a set of metadata corresponding to the (specific) playback condition, and extracting the one or more processing parameters for dynamic loudness adjustment from the selected set of metadata. Therein, the playback condition information may be indicative of the (specific) playback condition or information derived therefrom.

In some embodiments, the metadata may be indicative of processing parameters for dynamic loudness adjustment for a plurality of playback conditions.

In some embodiments, said determining the one or more processing parameters may further include determining one or more processing parameters for dynamic range compression, DRC, based on the playback condition.

In some embodiments, the playback condition information may be indicative of a specific loudspeaker setup. In general, the playback condition may include one or more of a device type of the decoder, characteristics of a playback device, characteristics of a loudspeaker, a loudspeaker setup, characteristics of background noise, characteristics of ambient noise and characteristics of the acoustic environment.

In some embodiments, the selected set of metadata may include a set of DRC sequences, DRCSet. Further, each of the sets of metadata may include a respective set of DRC sequences, DRCSet. In general, said determining the one or more processing parameters may be said to further include selecting, by the decoder, at least one of a set of DRC sequences, DRCSet, a set of equalizer parameters, EQSet, and a downmix, corresponding to the playback condition.

In some embodiments, said determining the one or more processing parameters may further include identifying a metadata identifier indicative of the at least one selected DRCSet, EQSet and downmix to determine the one or more processing parameters from the metadata. Specifically, selecting the set of metadata may include identifying a set of metadata corresponding to a specific downmix. The specific downmix may be determined based on the loudspeaker setup.

In some embodiments, the metadata may include one or more processing parameters relating to average loudness values and optionally one or more processing parameters relating to dynamic range compression characteristics. Specifically, each set of metadata may include such one or more processing parameters relating to average loudness values and optionally one or more processing parameters relating to dynamic range compression characteristics.

In some embodiments, the bitstream may further include additional metadata for static loudness adjustment to be applied to the decoded audio data.

In some embodiments, the bitstream may be an MPEG-D DRC bitstream and the presence of metadata may be signaled based on MPEG-D DRC bitstream syntax.

In some embodiments, a loudnessInfoSetExtension()-element may be used to carry the metadata as a payload.

In some embodiments, the metadata may comprise one or more metadata payloads, wherein each metadata payload may include a plurality of sets of parameters and identifiers, with each set including at least one of a DRCSet identifier, drcSetId, an EQSet identifier, eqSetId, and a downmix identifier, downmixId, in combination with one or more processing parameters relating to the identifiers in the set.

In some embodiments, said determining the one or more processing parameters may involve selecting a set among the plurality of sets in the payload based on the at least one DRCSet, EQSet, and downmix selected by the decoder, wherein the one or more processing parameters determined by the decoder may be the one or more processing parameters relating to the identifiers in the selected set.

In accordance with a second aspect of the present disclosure there is provided a decoder for metadata-based dynamic processing of audio data for playback. The decoder may comprise one or more processors and non-transitory memory configured to perform a method including receiving, by the decoder, a bitstream including audio data and metadata for dynamic loudness adjustment; decoding, by the decoder, the audio data and the metadata to obtain decoded audio data and the metadata; determining, by the decoder, from the metadata, one or more processing parameters for dynamic loudness adjustment based on a playback condition; applying the determined one or more processing parameters to the decoded audio data to obtain processed audio data; and outputting the processed audio data for playback.

The metadata for dynamic loudness adjustment may include a plurality of sets of metadata, with each set corresponding to a respective (e.g., different) playback condition. Then, determining the one or more processing parameters for dynamic loudness adjustment from the metadata based on a (specific) playback condition may include selecting, in response to playback condition information provided to the decoder, a set of metadata corresponding to the (specific) playback condition, and extracting the one or more processing parameters for dynamic loudness adjustment from the selected set of metadata. Therein, the playback condition information may be indicative of the (specific) playback condition or information derived therefrom.

In accordance with a third aspect of the present disclosure there is provided a method of encoding audio data and metadata for dynamic loudness adjustment, into a bitstream. The method may include inputting original audio data into a loudness leveler for loudness processing to obtain, as an output from the loudness leveler, loudness processed audio data. The method may further include generating the metadata for dynamic loudness adjustment based on the loudness processed audio data and the original audio data. And the method may include encoding the original audio data and the metadata into the bitstream.

In some embodiments, the metadata may include a plurality of sets of metadata. Each set of metadata may correspond to a respective (e.g., different) playback condition.

In some embodiments, the method may further include generating additional metadata for static loudness adjustment to be used by a decoder.

In some embodiments, said generating metadata may include comparison of the loudness processed audio data to the original audio data, wherein the metadata may be generated based on a result of said comparison.

In some embodiments, said generating metadata may further include measuring the loudness over one or more pre-defined time periods, wherein the metadata may be generated further based on the measured loudness.

In some embodiments, the measuring may comprise measuring overall loudness of the audio data.

In some embodiments, the measuring may comprise measuring loudness of dialogue in the audio data.

In some embodiments, the bitstream may be an MPEG-D DRC bitstream and the presence of the metadata may be signaled based on MPEG-D DRC bitstream syntax.

In some embodiments, a loudnessInfoSetExtension()-element may be used to carry the metadata as a payload.

In some embodiments, the metadata may comprise one or more metadata payloads, wherein each metadata payload may include a plurality of sets of parameters and identifiers, with each set including at least one of a DRCSet identifier, drcSetId, an EQSet identifier, eqSetId, and a downmix identifier, downmixId, in combination with one or more processing parameters relating to the identifiers in the set, and wherein the one or more processing parameters may be parameters for dynamic loudness adjustment by a decoder.

In some embodiments, the at least one of the drcSetId, the eqSetId, and the downmixId may be related to at least one of a set of DRC sequences, DRCSet, a set of equalizer parameters, EQSet, and downmix, to be selected by the decoder.

In accordance with a fourth aspect of the present disclosure there is provided an encoder for encoding in a bitstream original audio data and metadata for dynamic loudness adjustment. The encoder may comprise one or more processors and non-transitory memory configured to perform a method including inputting original audio data into a loudness leveler for loudness processing to obtain, as an output from the loudness leveler, loudness processed audio data; generating the metadata for dynamic loudness adjustment based on the loudness processed audio data and the original audio data; and encoding the original audio data and the metadata into the bitstream.

In accordance with a fifth aspect of the present disclosure there is provided a system of an encoder for encoding in a bitstream original audio data and metadata for dynamic loudness adjustment, and a decoder for metadata-based dynamic processing of audio data for playback.

In accordance with a sixth aspect of the present disclosure there is provided a computer program product comprising a computer-readable storage medium with instructions adapted to cause the device to carry out a method of metadata-based dynamic processing of audio data for playback or a method of encoding audio data and metadata for dynamic loudness adjustment, into a bitstream when executed by a device having processing capability.

In accordance with a seventh aspect of the present disclosure there is provided a computer-readable storage medium storing the computer program product described herein.

In accordance with an eighth aspect of the present disclosure there is provided a method of processing audio data for playback. The method may include receiving, by a decoder, a bitstream including encoded audio data and metadata, wherein the metadata includes one or more dynamic range control (DRC) sets, and for each DRC set, an indication of whether the DRC set is configured for providing a dynamic loudness compensation effect. The method may further include parsing the metadata, by the decoder, to identify DRC sets that are configured for providing the dynamic loudness compensation effect. The method may further include decoding, by the decoder, the encoded audio data to obtain decoded audio data. The method may further include selecting, by the decoder, one of the identified DRC sets configured for providing the dynamic loudness compensation effect. The method may further include applying to the decoded audio data, by the decoder, the one or more DRC gains corresponding to the selected DRC set to obtain dynamic loudness compensated audio data. And the method may include outputting the dynamic loudness compensated audio data for playback.

In some embodiments, the metadata may include a plurality of DRC sets configured for providing the dynamic loudness adjustment, wherein each of the plurality of DRC sets may also be associated with one or more playback conditions, and wherein the selecting may be performed in response to an indication of a playback condition provided to the decoder.

In some embodiments, in addition to providing a dynamic loudness compensation effect, the one or more DRC sets may also be configured to provide dynamic range control.

In some embodiments, the playback condition may include one or more of a device type of the decoder, characteristics of a playback device, characteristics of a loudspeaker, a loudspeaker setup, characteristics of background noise, characteristics of ambient noise and characteristics of the acoustic environment.

In some embodiments, the indication of whether the DRC set is configured for providing the dynamic loudness compensation effect may be provided in a parameter indicating one or more effects provided by the DRC set.

In some embodiments, the parameter indicating one or more effects provided by the DRC set may be a drcSetEffect bitfield of an MPEG-D DRC bitstream, wherein individual bits of the drcSetEffect bitfield correspond to different effects, and one of the bits of the drcSetEffect bitfield corresponds to the dynamic loudness compensation effect.

In some embodiments, the indication of whether the DRC set is configured for providing the dynamic loudness compensation effect may be whether the DRC set is specified in a dynamic loudness compensation bitstream payload.

In some embodiments, the dynamic loudness compensation bitstream payload may be included in an extension field of a previously defined bitstream syntax.

In some embodiments, the extension field may be a uniDrcConfigExtension field of an MPEG-D DRC bitstream, and the dynamic loudness compensation bitstream payload may be included only for specific values of a uniDrcConfigExtType parameter.

In some embodiments, a plurality of dynamic loudness compensation payloads specifying a plurality of DRC sets configured for providing the dynamic loudness compensation effect may be included in the extension field of the previously defined bitstream syntax.

In some embodiments, the indication of whether the DRC set is configured for providing the dynamic loudness compensation effect may be a field of a previously existing configuration element of a previously defined bitstream syntax.

In some embodiments, the field may be a dynamicLoudCompDRCSet parameter, and the previously existing configuration element may be a downmixInstructions element, a drcInstructionsBasic element, or a drcInstructionsUniDRC element of an MPEG-D DRC bitstream.

In some embodiments, the field may be a previously existing field reserved for future use.

In some embodiments, the indication of whether the DRC set is configured for providing the dynamic loudness compensation effect may be a field of an updated version of a previously existing configuration element of a previously defined bitstream syntax.

In some embodiments, the field may be a dynamicLoudCompDRCSet parameter, and the updated version of the previously existing configuration element may be a downmixInstructionsV2 element or a drcInstructionsUniDrcV2 element.

In some embodiments, an indication that a dynamic loudness compensation effect is desired may be provided to the decoder through an interface, and the DRC set may be selected in response to the indication provided to the decoder through the interface.

In some embodiments, indications of additional desired effects may be provided to the decoder through the interface, the metadata may include a plurality of DRC sets configured to provide the dynamic loudness compensation effect, and the selection may depend on the additional desired effects.

In some embodiments, the indication that a dynamic loudness compensation effect is desired may be provided through a drcEffectTypeRequest parameter of a dynamicRangeControllerInterface payload.

In some embodiments, the metadata may include one or more static loudness values configured for providing static loudness adjustment to the decoded audio data.

In some embodiments, static loudness adjustment may be applied, in response to one or more of the static loudness values, to the decoded audio data or the dynamic loudness compensated audio data.

In some embodiments, a first one of the DRC sets may be configured for providing dynamic range control, and the first DRC set may comprise an indication that the selected DRC set configured for providing the dynamic loudness compensation effect may be configured for application in combination with the first DRC set.

In some embodiments, the selected DRC set may comprise an indication of whether the one or more DRC gains corresponding to the selected DRC set may only be applied in combination with DRC gains corresponding to the first DRC set.

In some embodiments, DRC gains corresponding to the first DRC set may be extracted from the bitstream and may be applied to the decoded audio data.

In accordance with a ninth aspect of the present disclosure there is provided a decoder for processing audio data for playback. The decoder may comprise one or more processors and non-transitory memory configured to perform a method of processing audio data for playback as described above.

In accordance with a tenth aspect of the present disclosure there is provided a computer program product comprising a computer-readable storage medium with instructions adapted to cause the device to carry out a method of processing audio data for playback as described above.

In accordance with an eleventh aspect of the present disclosure there is provided a computer-readable storage medium storing the computer program product described herein.

### BRIEF DESCRIPTION OF THE DRAWINGS

Example embodiments of the disclosure will now be described, by way of example only, with reference to the accompanying drawings in which:
FIG. 1 illustrates an example of a decoder for metadata-based dynamic processing of audio data for playback.
FIG. 2 illustrates an example of a method of metadata-based dynamic processing of audio data for playback.
FIG. 3 illustrates an example of an encoder for encoding in a bitstream original audio data and metadata for dynamic loudness adjustment.
FIG. 4 illustrates an example of a method of encoding audio data and metadata for dynamic loudness adjustment, into a bitstream.
FIG. 5 illustrates an example of a device comprising one or more processors and non-transitory memory configured to perform the methods described herein.
FIG. 6 illustrates an example of a method of processing audio data for playback.

### DESCRIPTION OF EXAMPLE EMBODIMENTS

### Overview

The average loudness of a program or dialogue is the main parameter or value used for loudness compliance of broadcast or streaming programs. The average loudness is typically set to -24 or - 23 LKFS. With audio codecs that support loudness metadata, this single loudness value representing the loudness of the entire program, is carried in the bitstream. Using this value in the decoding process allows gain adjustments that result in predictable playback levels, so that programs play back at known consistent levels. Therefore, it is important that this loudness value is set properly and accurately. Since the average loudness is dependent on measuring the entire program prior to encoding, for real-time situations such as dynamic encoding with unknown loudness and dynamic range variation, this is, however, not possible.

When it is not possible to measure the loudness of the entire file prior to encoding, a dynamic loudness leveler is often used to modify or contour the audio data prior to encoding so that it meets the required loudness. This type of loudness management is often seen as an inferior method to meet compliance, as it often changes the dynamic range intercorrelation in the audio content and may thus change the creative intent. This is especially the case when it is desired to distribute one audio asset for all playback devices, which is one of the benefits of metadata driven codec and delivering systems.

In some approaches, audio content is mixed with the required target loudness, and the corresponding loudness metadata is set to that value. A loudness leveler might still be used in those situations as it will be used to help steer the audio content to the target loudness but it will not be that "active" and is only used to when the audio content starts to deviate from the required target loudness.

In view of the above, methods and apparatus described herein aim at making real-time processing situations, also denoted as dynamic processing situations, also metadata driven. The metadata allow for dynamic loudness adjustment and dynamic range compression in real-time situations. The methods and apparatus as described advantageously enable:
- Use of real-time loudness adjustment and DRC in MPEG-D DRC syntax;
- Use of real-time loudness adjustment and DRC in combination with downmixId;
- Use of real-time loudness adjustment and DRC in combination with drcSetId;
- Use of real-time loudness adjustment and DRC in combination with eqSetId.

That is, depending on decoder settings (e.g., DRCSet, EQSet, and downmix), a decoder can search based on the syntax a given payload for an appropriate set of parameters and identifiers, by matching the aforementioned settings to the identifiers. The parameters included in the set whose identifiers best match the settings can then be selected as the processing parameters for dynamic loudness adjustment to be applied to received original audio data for correction.

Further, multiple sets of parameters for dynamic processing (multiple instances of dynLoudCompValue) can be transmitted.

The metadata-driven dynamic loudness compensation, in addition to correcting the overall loudness, can also be used to "center" the DRC gain calculation and application. This centering may be a result of correcting the loudness of the content, via the dynamic loudness compensation, and how DRC is typically calculated and applied. In this sense, metadata for dynamic loudness compensation can be said to be used for aligning DRC parameters.

### Metadata-based dynamic processing of audio data

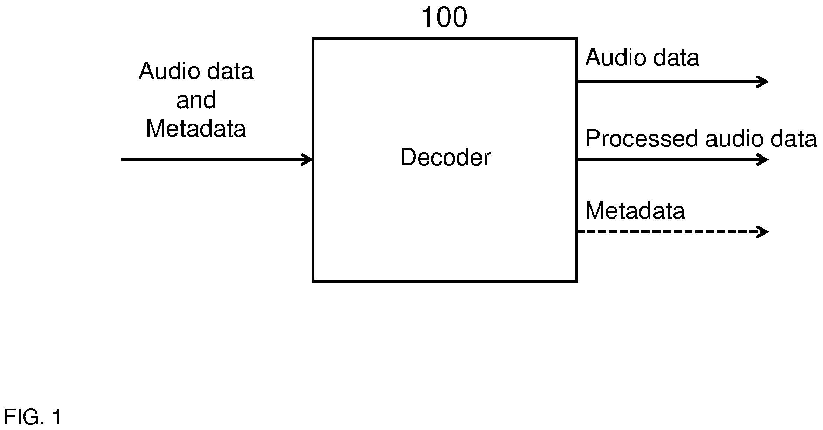

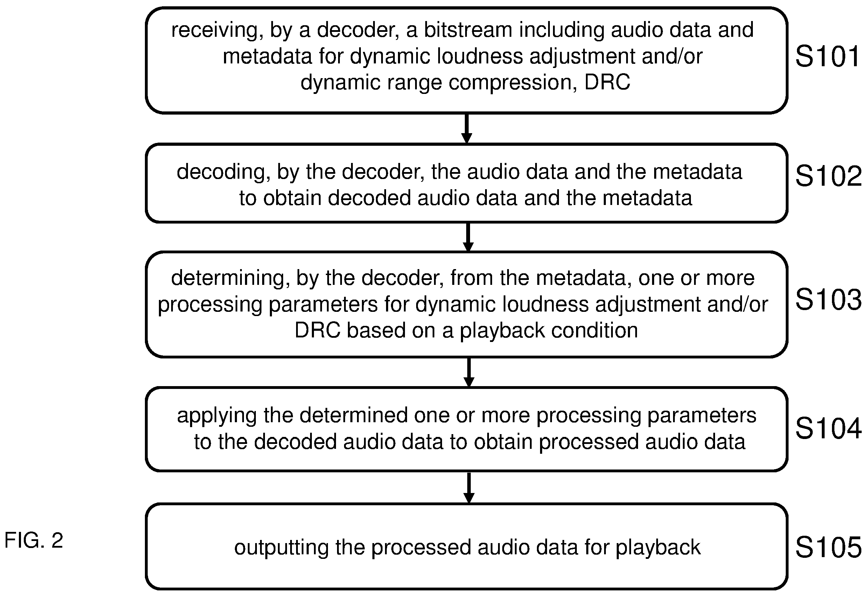

Referring to the example of Figure 1, a decoder 100 for metadata-based dynamic processing of audio data for playback is described. The decoder 100 may comprise one or more processors and non-transitory memory configured to perform a method including the processes as illustrated in the example of Figure 2 by means of steps S101 to S105.

The decoder 100, may receive a bitstream including audio data and metadata and may be able to output the unprocessed (original) audio data, the processed audio data after application of dynamic processing parameters determined from the metadata and/or the metadata itself depending on requirements.

Referring to the example of Figure 2, in step S101 the decoder 100 may receive a bitstream including audio data and metadata for dynamic loudness adjustment and optionally, dynamic range compression (DRC). The audio data may be encoded audio data, the audio data may further be unprocessed. That is, the audio data may be said to be original audio data. The metadata may include a plurality of sets of metadata. For example, each payload of metadata may include such plurality of sets of metadata. These different sets of metadata may relate to respective playback conditions (e.g., to different playback conditions).

While the format of the bitstream is not limited, in an embodiment, the bitstream may be an MPEG-D DRC bitstream. The presence of metadata for dynamic processing of audio data may then be signaled based on MPEG-D DRC bitstream syntax. In an embodiment, a loudnessInfoSetExtension()-element may be used to carry the metadata as a payload as detailed further below.

In step S102, the audio data and the metadata may then be decoded, by the decoder, to obtain decoded audio data and the metadata. In an embodiment, the metadata may include one or more processing parameters relating to average loudness values and optionally one or more processing parameters relating to dynamic range compression characteristics. It is understood that each set of metadata may include respective processing parameters. The metadata allows to apply dynamic or real-time correction. For example, when encoding and decoding for live real-time playout, the application of the "real-time" or dynamic loudness metadata is desired to ensure that the live playout audio is properly loudness managed.

In step S103, the decoder then determines, from the metadata, one or more processing parameters for dynamic loudness adjustment based on a playback condition. This may be done by using the playback condition or information derived from the playback condition (e.g., playback condition information), to identify an appropriate set of metadata among the plurality of sets of metadata.

In an embodiment, a playback condition may include one or more of a device type of the decoder, characteristics of a playback device, characteristics of a loudspeaker, a loudspeaker setup, characteristics of background noise, characteristics of ambient noise and characteristics of the acoustic environment. Preferably, the playback condition information may be indicative of a specific loudspeaker setup. The consideration of a playback condition allows the decoder for a targeted selection of processing parameters for dynamic loudness adjustment with regard to device and environmental constraints.

In an embodiment, the process of determining the one or more processing parameters in step S103 may further include selecting, by the decoder, at least one of a set of DRC sequences, DRCSet, set of equalizer parameters, EQSet, and a downmix, corresponding to the playback condition. Thus, the at least one of a DRCSet, EQSet and downmix correlates with or is indicative of the individual device and environmental constraints due to the playback condition.

Preferably, step S103 involves selecting a set of DRC sequences, DRCSet. In other words, the selected set of metadata may include such set of DRC sequences.

In an embodiment, the process of determining in step S103 may further include identifying a metadata identifier indicative of the at least one selected DRCSet, EQSet and DownmixSet to determine the one or more processing parameters from the metadata. The metadata identifier thus enables to connect the metadata with a corresponding selected DRCSet, EQSet, and/or downmix, and thus with a respective playback condition.

In an embodiment, the specific loudspeaker setup may be used to determine a downmix, which in turn may be used for identifying and selecting an appropriate one among the plurality of sets of metadata. In such case, the specific loudspeaker setup and/or the downmix may be indicated by the aforementioned playback condition information.

In an embodiment, the metadata may comprise one or more metadata payloads (e.g., dynLoudComp() payloads, such as shown in *Table* 5 below), wherein each metadata payload may include a plurality of sets of parameters (e.g., parameters dynLoudCompValue) and identifiers, with each set including at least one of a DRCSet identifier, drcSetId, an EQSet identifier, eqSetId, and a downmix identifier, downmixId, in combination with one or more processing parameters relating to the identifiers in the set. That is, each payload may comprise an array of entries, each entry including processing parameters and identifiers (e.g., drcSetId, eqSetId, downmixId). The array of entries may correspond to the plurality of sets of metadata mentioned above. Preferably, each entry comprises the downmix identifier.

In a further embodiment, the determining in step S103 may thus involve selecting a set among the plurality of sets in the payload based on the downmix selected by the decoder (or alternatively, based on the at least one DRCSet, EQSet, and downmix), wherein the one or more processing parameters determined in step S103 may be the one or more processing parameters relating to the identifiers in the selected set. That is, depending on settings (e.g., DRCSet, EQSet, and downmix) present in the decoder, the decoder can search a given payload for an appropriate set of parameters and identifiers, by matching the aforementioned settings to the identifiers. The parameters included in the set whose identifiers best match the settings can then be selected as the processing parameters for dynamic loudness adjustment.

In step S104, the determined one or more processing parameters may then be applied, by the decoder, to the decoded audio data to obtain processed audio data. The processed audio data, for example live real-time audio data, are thus properly loudness managed.

In step S105, the processed audio data may then be output for playback.

In an embodiment, the bitstream may further include additional metadata for static loudness adjustment to be applied to the decoded audio data. Static loudness adjustment refers in contrast to dynamic processing for real-time situations to processing performed for general loudness normalization.

Carrying the metadata for dynamic processing separately from the additional metadata for general loudness normalization allows to not have the "real-time" correction applied.

For example, when encoding and decoding for live real-time playout, the application of dynamic processing is desired to ensure that the live playout audio is properly loudness managed. But for a non-real-time playout, or a transcoding where the dynamic correction is not desired or required, the dynamic processing parameters determined from the metadata do not have to be applied.

By further keeping the (dynamic/real-time) metadata for dynamic processing separate from the additional metadata, the originally unprocessed content can be retained, if desired. The original audio is encoded along with the metadata. This allows the playback device to selectively apply the dynamic processing and to further enable playback of original audio content on high-end devices capable of playing back original audio.

Keeping the dynamic loudness metadata distinct from the long-term loudness measurement/information, such as contentLoudness (in ISO/IEC 23003-4) as described above has some advantages. If combined, the loudness of the content (or what it should be after the dynamic loudness metadata is applied) would not indicate the actual loudness of the content, as the metadata available would be a composite value. Besides removing this ambiguity of what the content loudness (or program or anchor loudness) is, there are some cases where this would be particularly beneficial:
Keeping the metadata for dynamic processing separate allows the decoder or playback device to turn off the application of dynamic processing and to apply an implemented real-time loudness leveler instead to avoid cascading leveling. This situation may occur, for example, if the device's own real-time leveling solution is superior to the one used with the audio codec or, for example, if the device's own real-time leveling solution cannot be disabled and therefore will always be active, resolution in further processing leading to a compromised playback experience.

Keeping the metadata for dynamic processing separate further allows transcoding to a codec that does not support dynamic loudness processing and one wishes to apply their own loudness processing prior to re-encoding.

Live to broadcast, with a single encode for a live feed would be a further example. The dynamic processing metadata may be used or stored for archive or on-demand services. Therefore, for the archive or on-demand services, a more accurate, or compliant loudness measurement, based on the entire program can be carried out, and the appropriate metadata reset.

For use-cases where a fixed target loudness is used throughout the workflow, for example in a R128 compliant situation where -23 LKFS is recommended, this is also beneficial. In this scenario, the addition of the dynamic processing metadata is a "safety" measure, where the content is assumed and close to the required target and the addition of the dynamic processing metadata is a secondary check. Thus, having the ability to turn it off is desirable.

### Encoding audio data and metadata for dynamic loudness adjustment

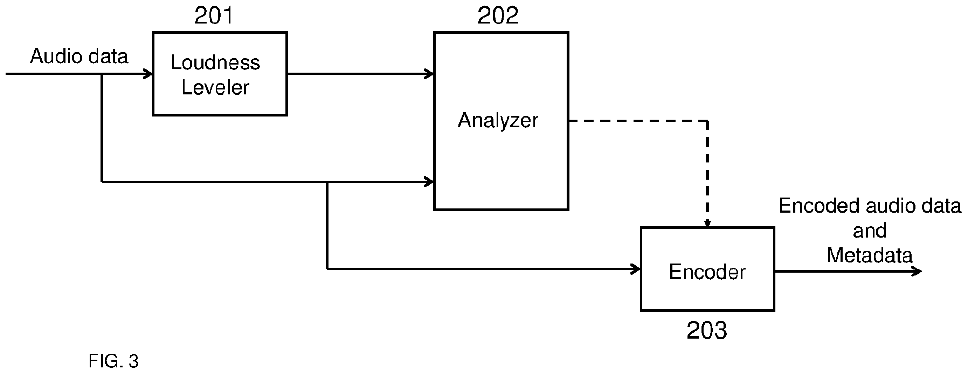

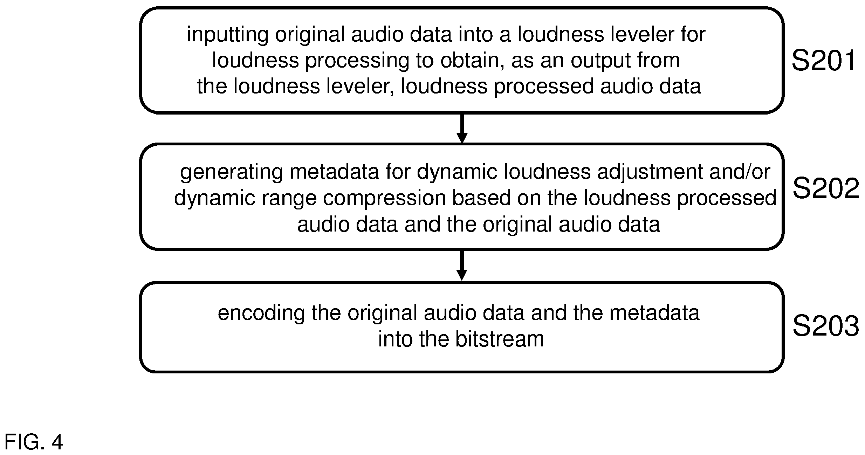

Referring to the examples of Figures 3 and 4, an encoder for encoding in a bitstream original audio data and metadata for dynamic loudness adjustment and optionally, dynamic range compression, DRC, is described which may comprise one or more processors and non-transitory memory configured to perform a method including the processes as illustrated in the steps in the example of Figure 4.

In step S201, original audio data may be input into a loudness leveler, 201, for loudness processing to obtain, as an output from the loudness leveler, 201, loudness processed audio data.

In step S202, metadata for dynamic loudness adjustment may then be generated based on the loudness processed audio data and the original audio data. Appropriate smoothing and time frames may be used to reduce artifacts.

In an embodiment, step S202 may include comparison of the loudness processed audio data to the original audio data, by an analyzer, 202, wherein the metadata may be generated based on a result of said comparison. The metadata thus generated can emulate the effect of the leveler at the decoder site. The metadata may include:
- Gain (wideband and/or multiband) processing parameters such that when applied to the original audio will produced loudness compliant audio for playback;
- Processing parameters describing the dynamics of the audio such as
   o Peak - sample and true peak
   o Short-term loudness values
   o Change of short-term loudness values.

In an embodiment, step S202 may further include measuring, by the analyzer, 202, the loudness over one or more pre-defined time periods, wherein the metadata may be generated further based on the measured loudness. In an embodiment, the measuring may comprise measuring overall loudness of the audio data. Alternatively, or additionally, in an embodiment, the measuring may comprise measuring loudness of dialogue in the audio data.

In step S203, the original audio data and the metadata may then be encoded into the bitstream. While the format of the bitstream is not limited, in an embodiment, the bitstream may be an MPEG-D DRC bitstream and the presence of the metadata may be signaled based on MPEG-D DRC bitstream syntax. In this case, in an embodiment, a loudnessInfoSetExtension()-element may be used to carry the metadata as a payload as detailed further below.

In an embodiment, the metadata may comprise one or more metadata payloads, wherein each metadata payload may include a plurality of sets of parameters and identifiers, with each set including at least one of a DRCSet identifier, drcSetId, an EQSet identifier, eqSetId, and a downmix identifier, downmixId, in combination with one or more processing parameters relating to the identifiers in the set, and wherein the one or more processing parameters may be parameters for dynamic loudness adjustment by a decoder. In this case, in an embodiment, the at least one of the drcSetId, the eqSetId, and the downmixId may be related to at least one of a set of DRC sequences, DRCSet, a set of equalizer parameters, EQSet, and a downmix, to be selected by the decoder. In general, the metadata may be said to include a plurality of sets of metadata, with each set corresponding to a respective playback condition (e.g., to a different playback condition).

In an embodiment, the method may further include generating additional metadata for static loudness adjustment to be used by a decoder. Keeping the metadata for dynamic loudness processing and the additional metadata separate in the bitstream and encoding further the original audio data into the bitstream has several advantages as detailed above.

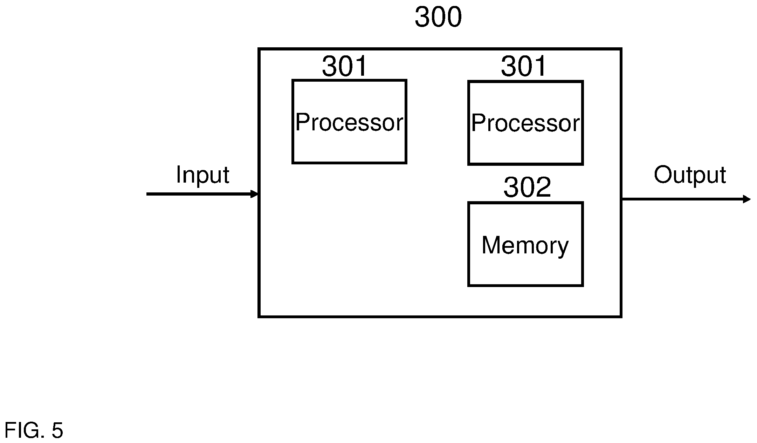

The methods described herein may be implemented on a decoder or an encoder, respectively, wherein the decoder and the encoder may comprise one or more processors and non-transitory memory configured to perform said methods. An example of a device having such processing capability is illustrated in the example of Figure 5 showing said device, 300, including two processors, 301, and non-transitory memory, 302.

It is noted that the methods described herein can further be implemented on a system of an encoder for encoding in a bitstream original audio data and metadata for dynamic loudness adjustment and optionally, dynamic range compression, DRC, and a decoder for metadata-based dynamic processing of audio data for playback as described herein.

The methods may further be implemented as a computer program product comprising a computer-readable storage medium with instructions adapted to cause the device to carry out said methods when executed by a device having processing capability. The computer program product may be stored on a computer-readable storage medium.

### MPEG-D DRC modified bitstream syntax

In the following, it will be described how the MPEG-D DRC bitstream syntax, as described in ISO/IEC 23003-4, may be modified in accordance with embodiments described herein.

The MPEG-D DRC syntax may be extended, e.g. the ***loudnessInfoSetExtension()-***element shown in **Table 2** below, in order to also carry the dynamic processing metadata as a frame-based *dynLoudComp* update.

For example, another switch-case UNIDRCLOUDEXT_DYNLOUDCOMP may be added in the ***loudnessInfoSetExtension()***-element as shown in ***Table 1**.* The switch-case UNIDRCLOUDEXT_DYNLOUDCOMP may be used to identify a new element ***dynLoudComp()*** as shown in ***Table 5**.* The ***loudnessInfoSetExtension()***-element may be an extension of the **loudnessInfoSet()**-element as shown in ***Table 2.*** Further, the ***loudnessInfoSet()-***element may be part of the ***uniDRC()***-element as shown in **Table 3.**

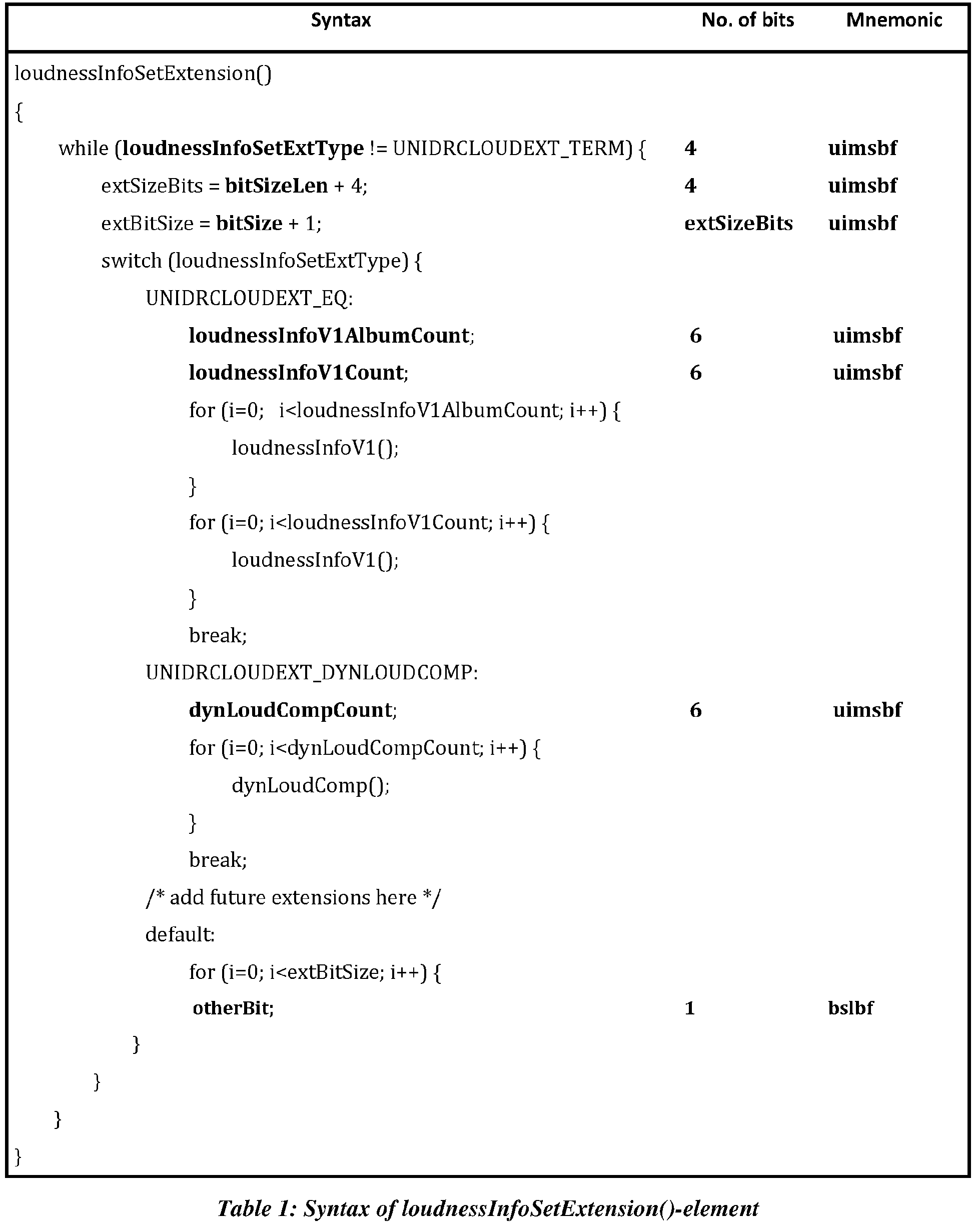

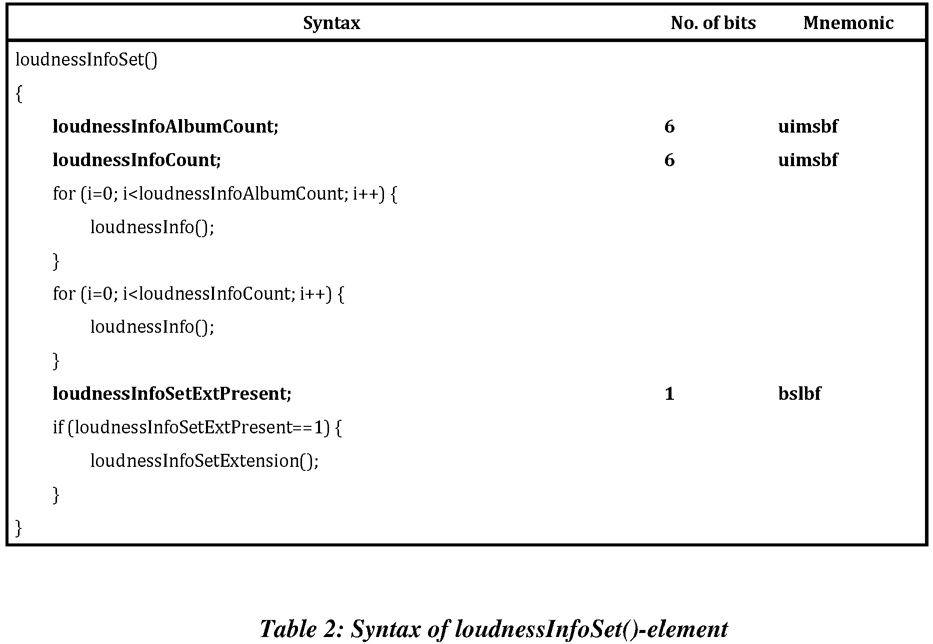

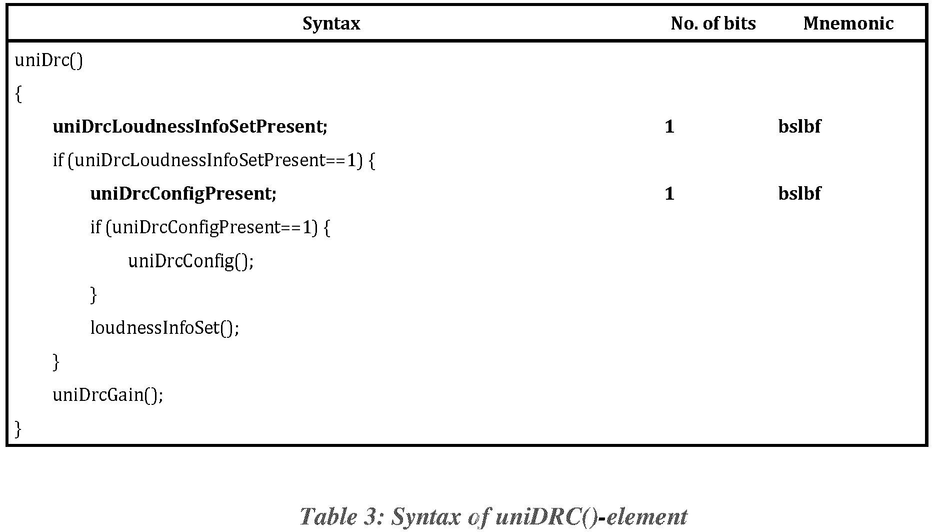

**Table 4: loudnessInfoSet extension types**

| **Symbol** | **Value of loudnessinfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| *(reserved)* | *(All remaining values)* | For future use |

### New dynLoudComp():

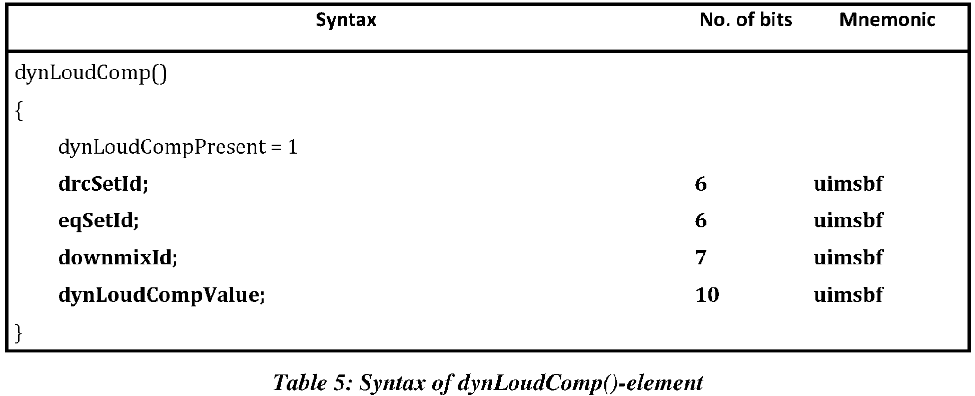

- The drcSetId enables dynLoudComp (relating to the metadata) to be applied per DRCset.
- The eqSetId enables dynLoudComp to be applied in combination with different settings for the equalization tool.
- The downmixId enables dynLoudComp to be applied per DownmixID.

In some cases, in addition to the above parameters, it may be beneficial for the dynLoudComp() element to also include a **methodDefinition** parameter (specified by, e.g., 4 bits) specifying a loudness measurement method used for deriving the dynamic program loudness metadata (e.g., anchor loudness, program loudness, short-term loudness, momentary loudness, etc.) and/or a **measurementSystem** parameter (specified by, e.g., 4 bits) specifying a loudness measurement system used for measuring the dynamic program loudness metadata (e.g., EBU R.128, ITU-R BS-1770 with or without preprocessing, ITU-R BS-1771, etc.). Such parameters may, e.g., be included in the dynLoudComp() element between the **downmixId** and **dynLoudCompValue** parameters.

### Alternative Syntax 1

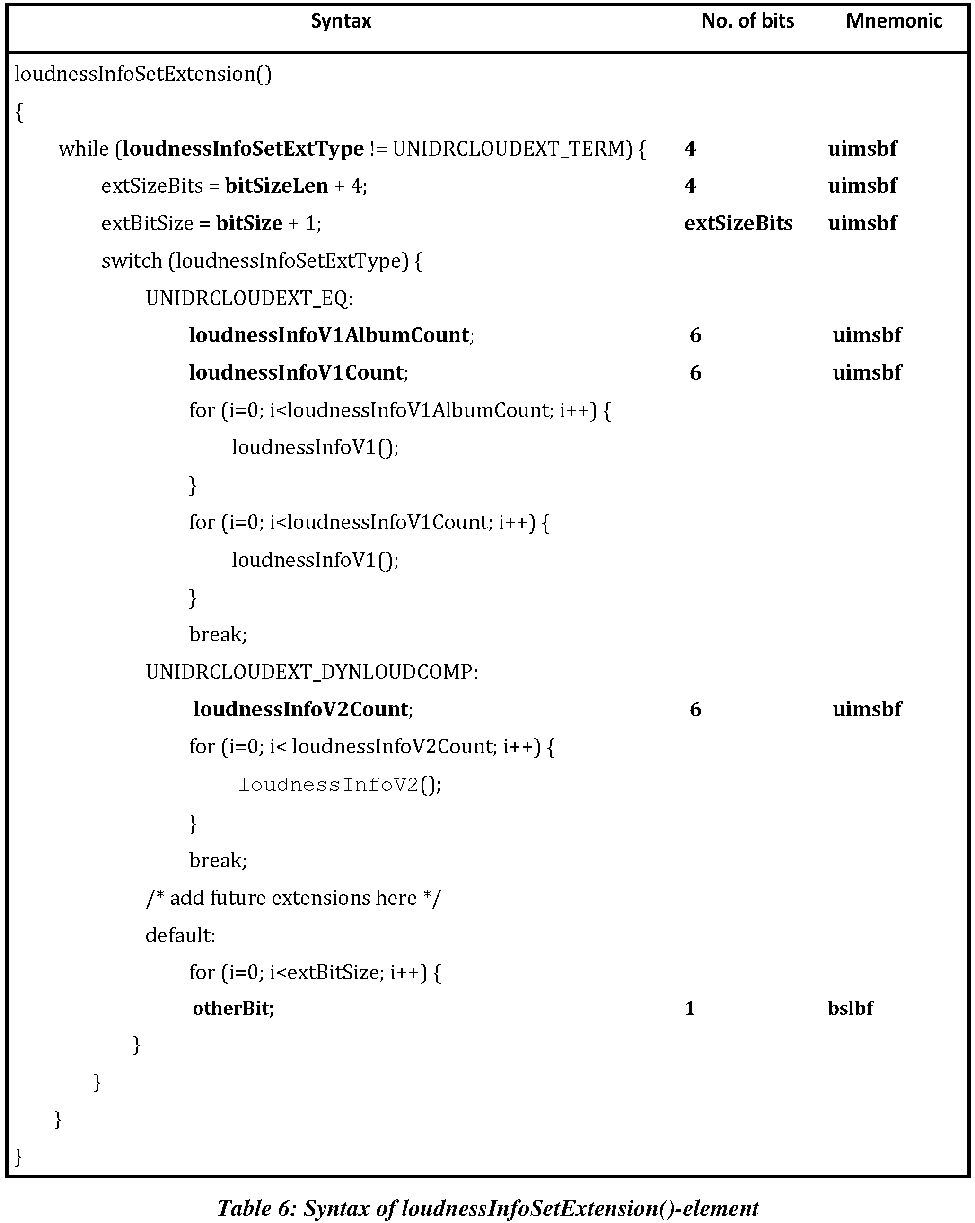

**Table 7: loudnessInfoSet extension types**

| **Symbol** | **Value of loudnessInfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| *(reserved)* | *(All remaining values)* | For future use |

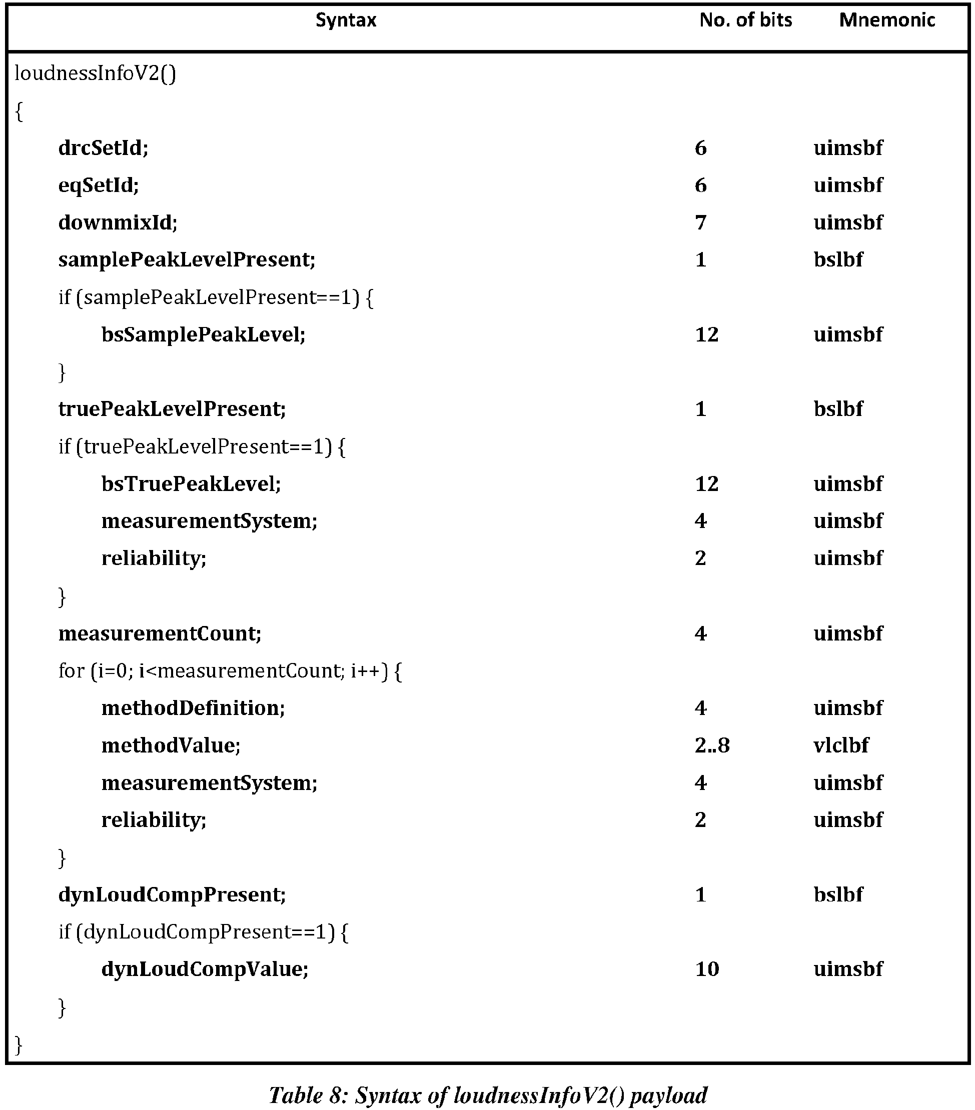

In some cases, it may be beneficial to modify the syntax shown above in Table 8 such that the **dynLoudCompPresent** and (if dynLoudCompPresent==1) **dynLoudCompValue** parameters follow the **reliability** parameter within the measurementCount loop of the loudnessInfoV2() payload, rather than being outside the measurementCount loop. Furthermore, it may also be beneficial to set dynLoudCompValue equal to 0 in cases where dynLoudCompPresent is 0.

### Alternative Syntax 2

Alternatively, the dynLoudComp()-element could be placed into the uniDrcGainExtension()-element.

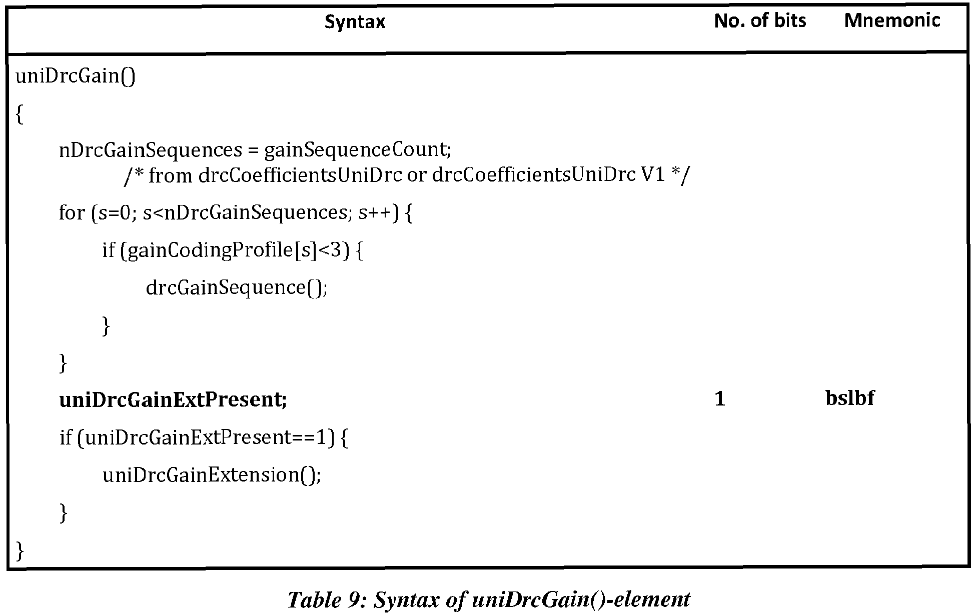

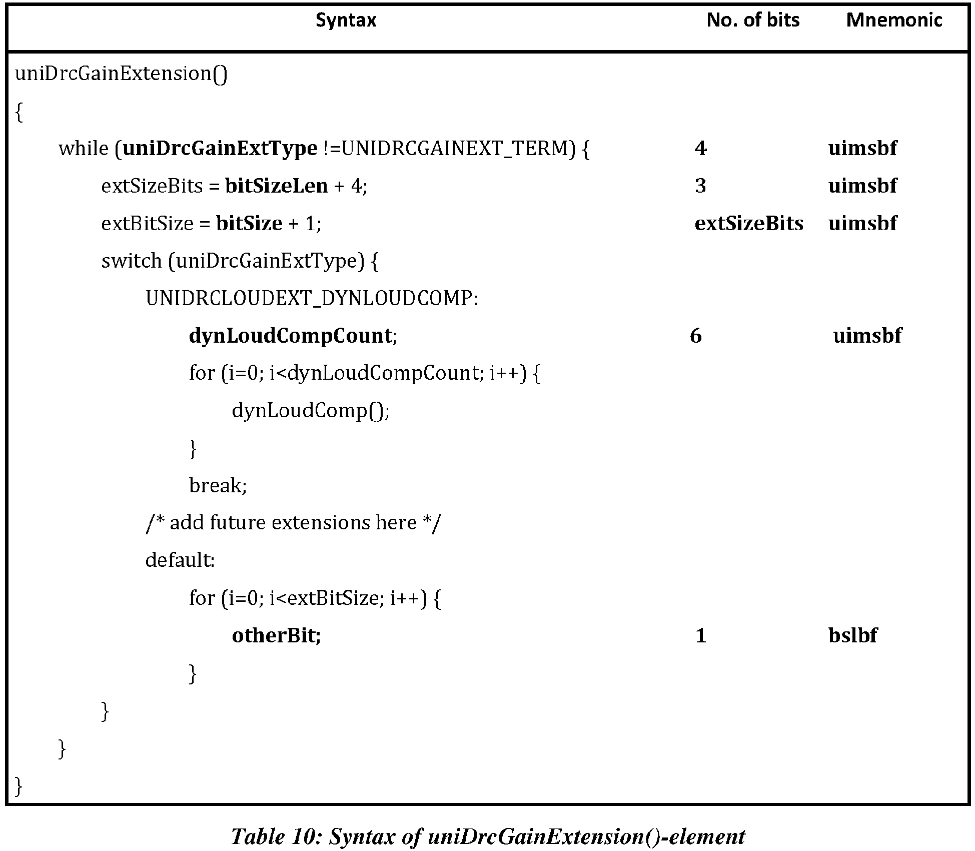

**Table 11: UniDrc gain extension types**

| **Symbol** | **Value of uniDrcGainExtType** | **Purpose** |
|---|---|---|
| UNIDRCGAINEXT_TERM | 0x0 | Termination tag |
| UNIDRCGAINEXT_DYNLOUDCOMP | 0×1 | Extension for dynamic processing |
| *(reserved)* | *(All remaining values)* | For future use |

### Semantics

| | |
|---|---|
| **dynLoudCompValue** | This field contains the value for *dynLoudCompDb.* The values are encoded according to the table below. The default value is 0 dB. |

**Table 12: Coding of dynLoudCompValue field**

| **Encoding** | **Size** | **Mnemonic** | **Value in [dB]** | **Approximate range** |
|---|---|---|---|---|
| *µ* | 10 bits | uimsbf | *dynLoudCompDb =* -16 + *µ*2⁻⁵ | -16 ... 16 dB, 0.0312 dB step size |

### Updated MPEG-D DRC Loudness Normalization Processing

**Table 13: Loudness normalization processing**

| |
|---|
| ```
   if (targetLoudnessPresent) {
        if (dynLoudCompPresent) {
              loudnessNormalizationGainDb = targetLoudness - contentLoudness +
   dynLoudCompDb;
         } else {
             loudnessNormalizationGainDb = targetLoudness - contentLoudness;
         }
    } else {
        loudnessNormalizationGainDb = 0.0;
    }
   if (loudnessNormalizationGainDbMaxPresent) {
        loudnessNormalizationGainDb = min(loudnessNormalizationGainDb,
   loudnessNormalizationGainDbMax);
    }
   if (loudnessNormalizationGainModificationDbPresent) {
        gainNorm = pow(2.0, (loudnessNormalizationGainDb +
   loudnessNormalizationGainModificationDb) / 6);
    } else {
        gainNorm = pow(2.0, loudnessNormalizationGainDb / 6);
    }
   for (t=0; t<drcFrameSize; t++) {
        for (c=0; c<nChannels; c++) {
              audioSample[c][t] = gainNorm * audioSample[c][t];
         }
    }
``` |

In some cases, in addition to the selection process shown in pseudo-code above (e.g., taking drcSetId, eqSetID and downmixId into consideration for selecting a dynLoudCompValue parameter), it may be beneficial for the selection process to also take a **methodDefinition** parameter and/or a **measurementSystem** parameter into consideration for selecting a dynLoudCompValue parameter.

### Alternative Updated MPEG-D DRC Loudness Normalization Processing

**Table 14: Alternative Loudness normalization processing**

| |
|---|
| ```
   if (targetLoudnessPresent) {
         loudnessNormalizationGainDb = targetLoudness - contentLoudness + dynLoudCompDb;
    }
   else {
        loudnessNormalizationGainDb = 0.0;
    }
   if (loudnessNormalizationGainDbMaxPresent) {
        loudnessNormalizationGainDb = min(loudnessNormalizationGainDb,
   loudnessNormalizationGainDbMax);
    }
   if (loudnessNormalizationGainModificationDbPresent) {
        gainNorm = pow(2.0, (loudnessNormalizationGainDb +
   loudnessNormalizationGainModificationDb) / 6);
    } else {
        gainNorm = pow(2.0, loudnessNormalizationGainDb / 6);
    }
   for (t=0; t<drcFrameSize; t++) {
        for (c=0; c<nChannels; c++) {
              audioSample[c][t] = gainNorm * audioSample[c][t];
         }
    }
``` |

In cases where the alternative loudness normalization processing of Table 14 above is used, the loudness normalization processing pseudo-code described above may be replaced by the following alternative loudness normalization processing pseudo-code. Note that a default value of dynLoudCompDb, e.g., 0 dB, may be assumed to ensure that the value of dynLoudCompDb is defined, even for cases where dynamic loudness processing metadata is not present in the bitstream.

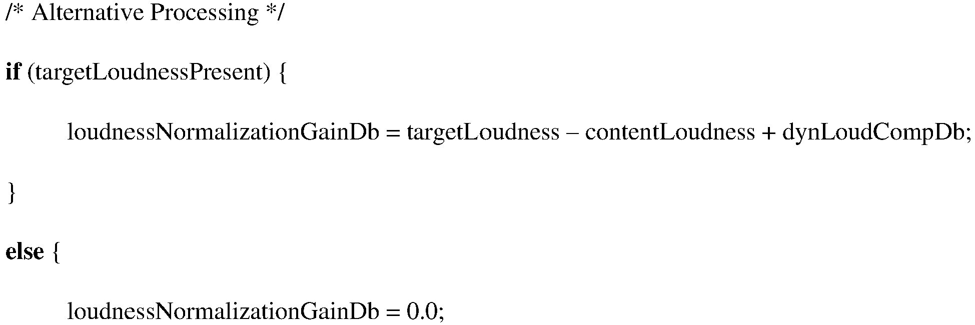

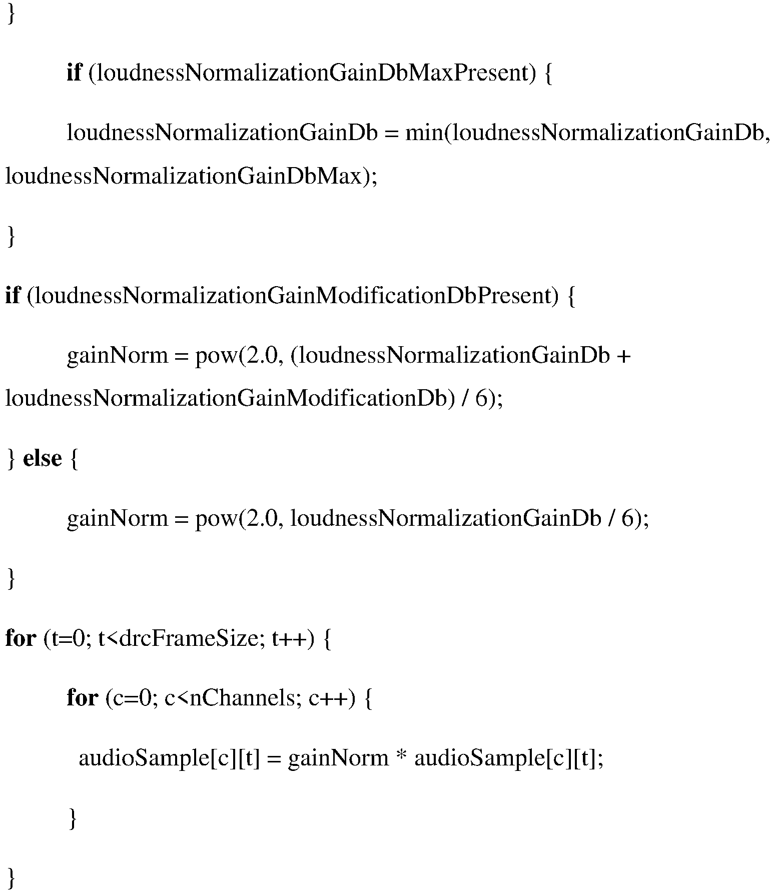

### Alternative Syntax 3

In some cases, it may be beneficial to combine the syntax described above in Table 1 - Table 5 with Alternative Syntax 1 described above in Table 6 - Table 8, as shown in the following Tables, to allow increased flexibility for transmission of the dynamic loudness processing values.

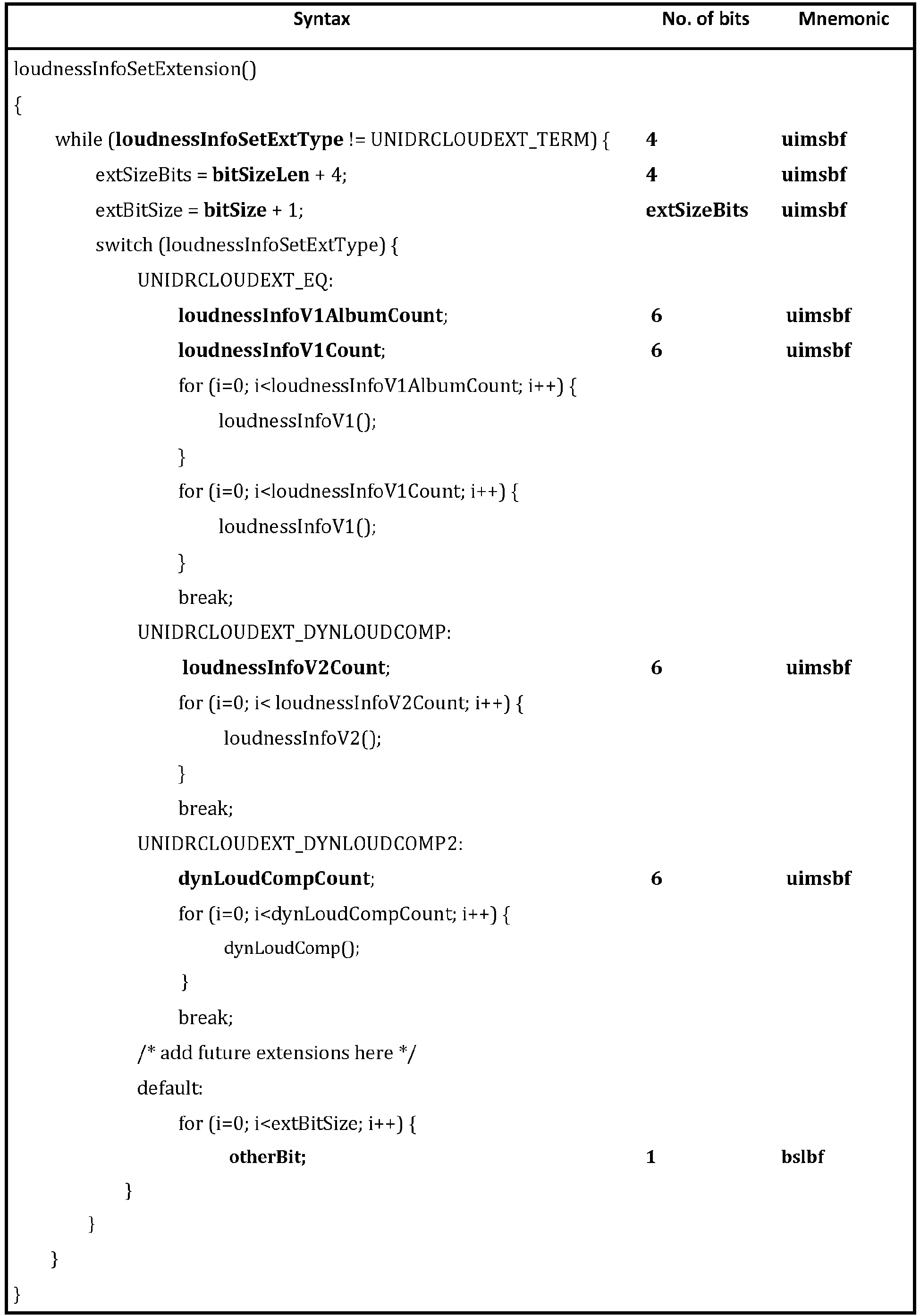

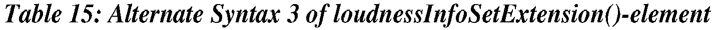

**Table 16: Alternate Syntax 3 of loudnessInfoSet extension types**

| **Symbol** | **Value of loudnessInfoSetExtType** | **Purpose** |
|---|---|---|
| UNIDRCLOUDEXT_TERM | 0×0 | Termination tag |
| UNIDRCLOUDEXT_EQ | 0×1 | Extension for equalization |
| UNIDRCLOUDEXT_DYNLOUDCOMP | 0×2 | Extension for dynamic processing |
| UNIDRCLOUDEXT_DYNLOUDCOMP2 | 0×3 | Extension for dynamic processing |
| *(reserved)* | *(All remaining values)* | For future use |

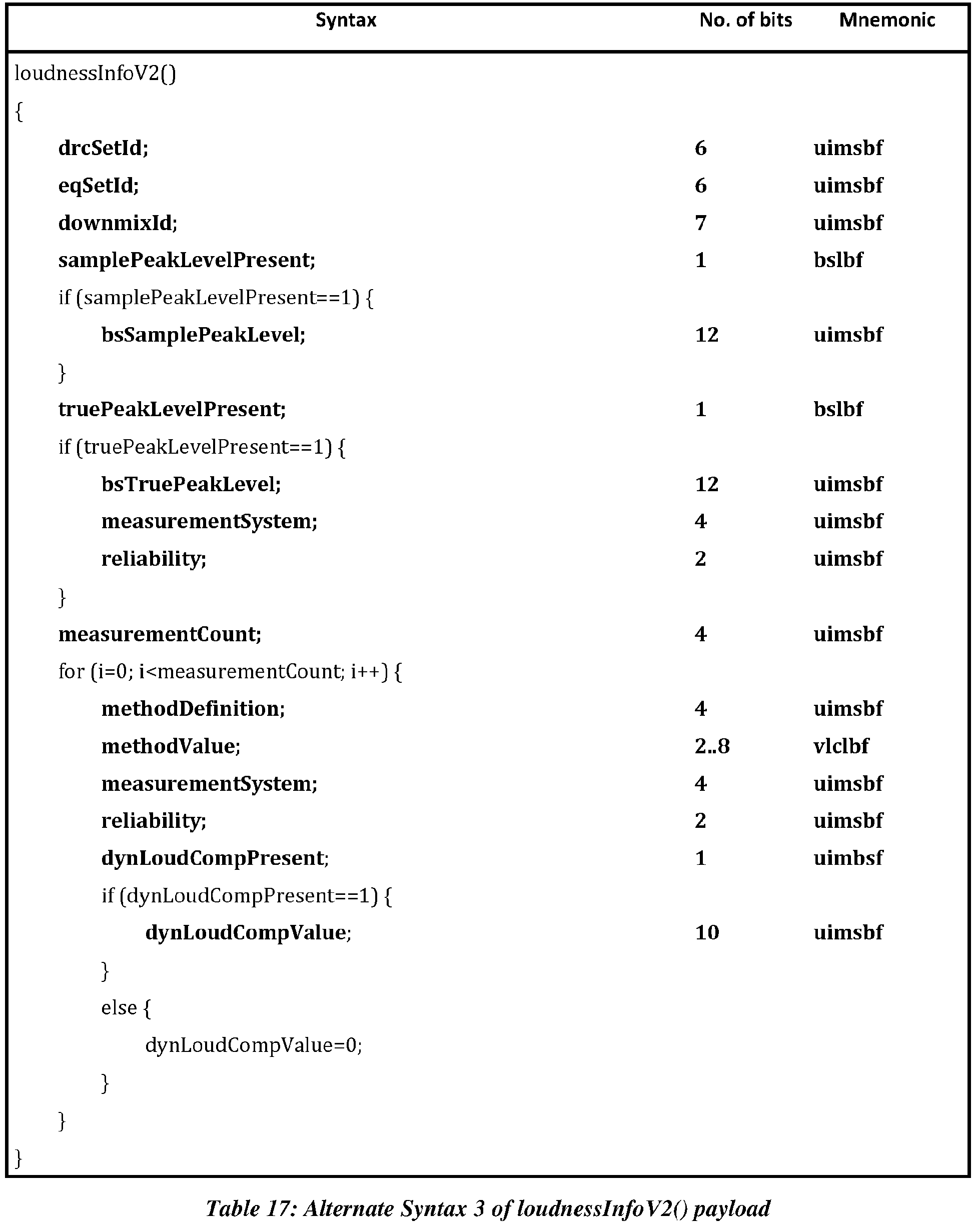

### Alternate Syntax 3 of dynLoudComp():

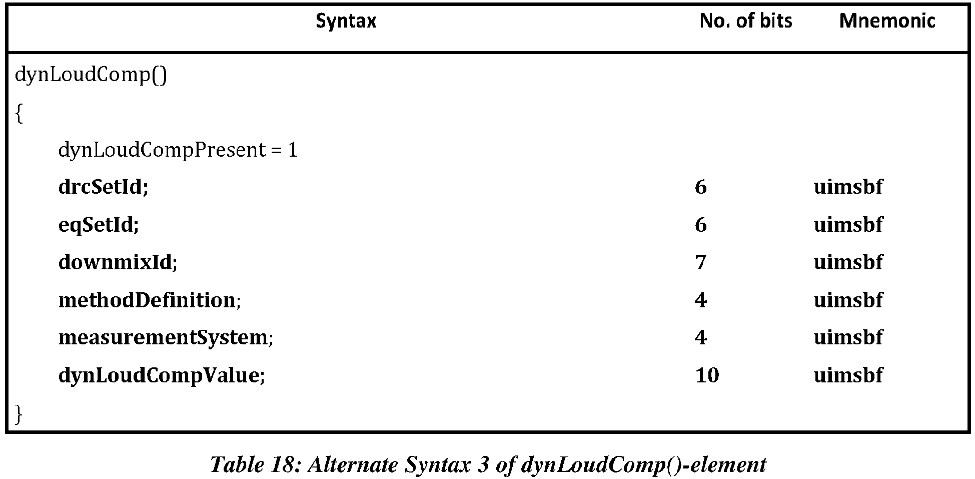

### Interface Extension Syntax

In some cases, it may be beneficial to allow control, e.g., by an end user, of whether or not dynamic loudness processing is performed, even when dynamic loudness processing information is present in a received bitstream. Such control may be provided by updating the MPEG-D DRC interface syntax to include an additional interface extension (e.g., UNIDRCINTERFACEEXT_DYNLOUD) which contains a revised loudness normalization control interface payload (e.g., loudnessNormalizationControlInterfaceV1()) as shown in the following tables.

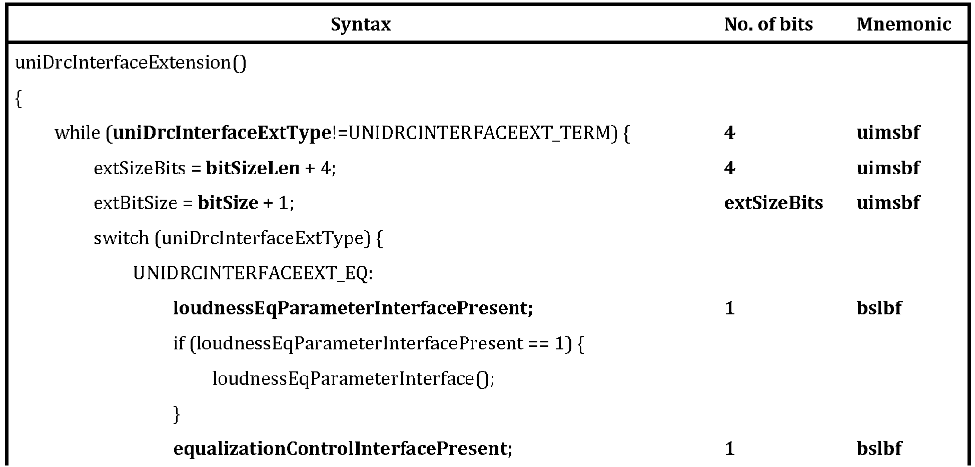

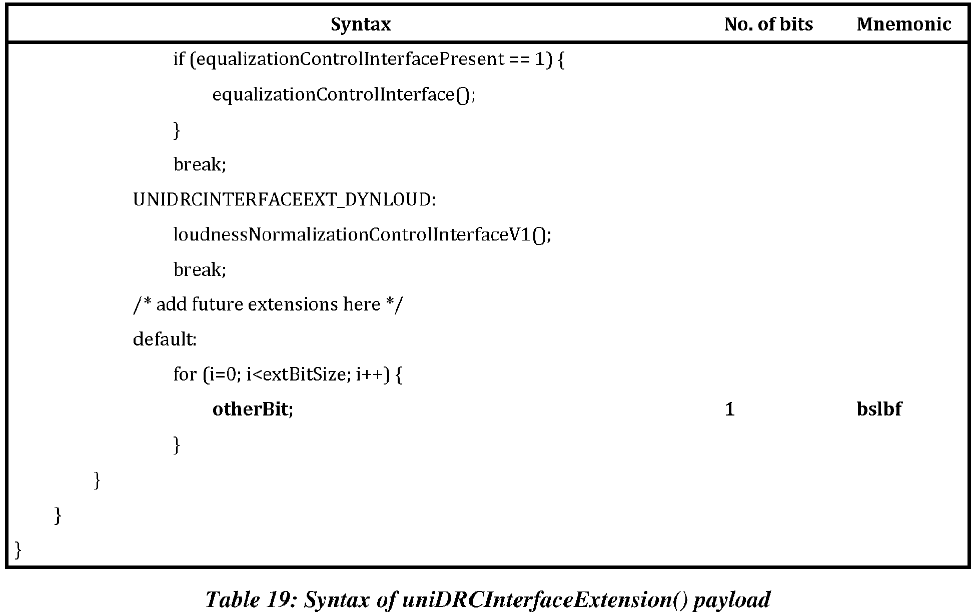

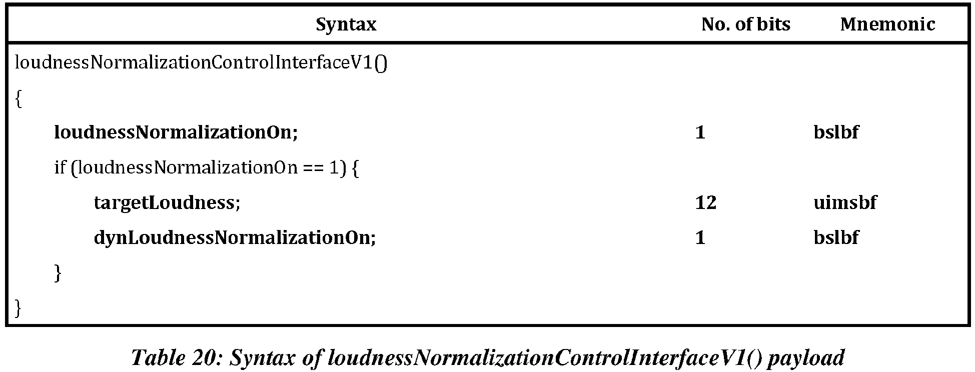

**Table 21: UniDRC Interface extension types**

| **Symbol** | **Value of uniDRCInterfaceExtType** | **Purpose** |
|---|---|---|
| UNIDRCINTERFACEEXT_TERM | 0×0 | Termination tag |
| UNIDRCINTERFACEEXT_EQ | 0×1 | Equalization Control |
| UNIDRCINTERFACEEXT_DYNLOUD | 0×2 | Dynamic Loudness Control |
| *(reserved)* | *(All remaining values)* | For future use |

### Interface Extension Semantics

| | |
|---|---|
| **loudnessNormalizationOn** | This flag signals if loudness normalization processing should be switched on or off. The default value is 0. If *loudnessNormalizationOn* == *0, loudnessNormalizationGainDb* shall be set to 0 dB. |
| **targetLoudness** | This field contains the desired output loudness. The values are encoded according to the following Table. |

**Table 22: Coding of targetLoudness field**

| **Encoding** | **Size** | **Mnemonic** | **Value in [dB]** | **Approximate range** |
|---|---|---|---|---|
| *µ* | 12 bits | uimsbf | *L_{TL} =*- *µ*2⁻⁵ | -128 ... 0 dB, 0.0312 dB step size |

| | |
|---|---|
| **dynLoudnessNormalizationOn** | This flag signals if dynamic loudness normalization processing should be switched on or off. The default value is 0. If *dynLoudnessNormalizationOn == 0, dynloudnessNormalizationGainDb* shall be set to 0 dB. |

### Additional Methods of Enabling Dynamic Loudness Compensation

In addition to the above, additional methods for enabling dynamic loudness compensation are possible. For example, instead of including a parameter which indicates a specific dynamic loudness compensation value to be applied to the signal, it is possible to define a specific set of DRC gains which already include the dynamic loudness compensation, such that, when those specific DRC gains are applied by a decoder, dynamic loudness compensation is applied. DRC gain sets suitable for applying such dynamic loudness compensation may be identified through specific bitstream elements, as explained further below. A benefit of such an approach is that it is not necessary to transmit an explicit dynamic loudness compensation gain in addition to other loudness information.

Additionally, a user can specify through an interface that the DRC gains including dynamic loudness compensation should be selected and applied, as explained further below.

Finally, additional bitstream elements may be provided to allow tighter creative control over whether and how dynamic loudness compensation is performed. For instance, a flag may indicate whether or not dynamic loudness compensation may be switched OFF by a user. In such cases, if the content creator allows for dynamic loudness compensation to be disabled, then dynamic loudness compensation will be applied or not as specified by the user.

### Specifying DRC Sets with Dynamic Loudness Compensation through the DRC Set Effect Field

In the MPEG-D DRC standard, it is possible to indicate one or more DRC effects which are provided by a specific DRC set. For instance, a DRC set might be appropriate for "Late Night" viewing, for viewing in "Noisy Environments", for viewing at "Low Playback Levels", etc. A DRC set effect parameter may indicate which specific effects are provided by the DRC set.

Furthermore, the MPEG-D DRC standard allows a user to specify one or more desired DRC effects, as well as one or more optional fallback DRC effects. Such information from a user may be used to select a most appropriate DRC set from the available DRC sets. For example, if a DRC set exists which matches the desired DRC effects, then that set is selected. If such a set does not exist, but there is a set that matches a fallback DRC effect, that set may be selected.

The list of defined DRC effects may be extended to include a DRC effect which provides dynamic loudness compensation. Furthermore, the list of DRC effects which can be specified by a user through an interface may also be extended to include a DRC set effect which provides dynamic loudness compensation. As such, dynamic loudness compensation may be provided by including a DRC set indicated as providing a dynamic loudness compensation effect, and indicating, through an interface, a desire for a DRC set which provides dynamic loudness compensation, in which case, the decoder would select and apply the DRC set that corresponds to the dynamic loudness compensation DRC effect.

As described above, a previous version of a table specifying DRC Set Effects that may be signaled in a bitstream (e.g., Table A.45 of ISO/IEC 23003-4:2020) may be updated to include an entry for a "Dynamic Loudness Compensation" effect as shown below. Specifically, a row with a particular bit position (e.g., 13) corresponding to a Dynamic Loudness Compensation effect may be added as shown in the table below.

**Table 23: Examples of DRC Effects**

| **bit position** | **drcSetEffect** | **Short name** | **Description** |
|---|---|---|---|
| 1 (LSB) | Late night | "Night" | For quiet environment, listening at low level, avoiding to disturb others. |
| 2 | Noisy environment | "Noisy" | Optimized to get the best experience in noisy environments, for instance by amplifying soft sections. |
| 3 | Limited playback range | "Limited" | Reduced dynamic range to improve quality on playback devices with limited dynamic range. |
| 4 | Low playback level | "LowLevel" | Listening at a low playback level. |
| 5 | Dialog enhancement | "Dialog" | The main effect is a more prominent dialogue within the content. |
| 6 | General compression | "General" | A DRC effect that reduces the dynamic range and is applicable to multiple playback scenarios. |
| 7 | Dynamic expansion | "Expand" | Dynamics enhancement. |
| 8 | Artistic effect | "Artistic" | To create an artistic sound effect. |
| 9 | Clipping prevention | "Clipping" | The main purpose is clipping prevention. |
| 10 | Fade-in/fade-out | "Fade" | Fade-in and fade-out envelope for gapless content (applicable when not playing in Album mode). It has no dynamic compression. |
| 11 | Ducking other | "Duck other" | An effect that attenuates all audio content except for the channelGroup it is associated with. It has no dynamic compression. |
| 12 | Ducking self | "Duck self" | An effect that attenuates all channelGroups that it is associated with. It is identical to "Ducking other", however, it has the same channelGroup assignment as regular DRC gains. |
| 13 | Dynamic Loudness Compensation | "Dyn Loud Comp" | An effect that compensates for dynamic loudness changes in the decoder. |
| *Remaining values are reserved* | | | |
| NOTE Any information on DRC sets with "Ducking" effect in this document shall refer to both "Ducking other" and "Ducking self" if not stated otherwise. | | | |

In the above example, a bit in a bitfield (e.g. a drcSetEffect bitfield of a drcInstructionsBasic() or a drcInstructionsUniDrc() or a drcInstructionsUniDrcV1() payload) associated with a particular DRC Set may be set (e.g., bit position 13) to indicate that the DRC Set provides the Dynamic Loudness Compensation effect.

Similarly, a previous version of a table specifying DRC Set Effects that may be specified to a decoder through an interface (e.g., Table 12 of ISO/IEC 23003-4:2020) may be updated to include an entry for a Dynamic Loudness Compensation effect as shown below. Specifically, a row with a particular Index Value (e.g., 9) corresponding to a Dynamic Loudness Compensation effect may be added as shown in the table below.

**Table 24: Examples of DRC Effects that may be specified through a interface**

| **Index** | **drcSetEffect** | **Short name** | **Description** |
|---|---|---|---|
| 0 | None | "None" | A DRC set that has no dynamic compression, for instance "Clipping", or applying no DRC set for compression. |
| 1 | Late night | "Night" | For quiet environment, listening at low level, avoiding to disturb others. |
| 2 | Noisy environment | "Noisy" | Optimized to get the best experience in noisy environments, for instance by amplifying soft sections. |
| 3 | Limited playback range | "Limited" | Reduced dynamic range to improve quality on playback devices with limited dynamic range. |
| 4 | Low playback level | "LowLevel" | Listening at a low playback level. |
| 5 | Dialog enhancement | "Dialog" | The main effect is a more prominent dialogue within the content. |
| 6 | General compression | "General" | A DRC effect that reduces the dynamic range and is applicable to multiple playback scenarios. |
| 7 | Dynamic expansion | "Expand" | Dynamics enhancement. |
| 8 | Artistic effect | "Artistic" | To create an artistic sound effect. |
| 9 | Dynamic Loudness Compensation | "DynLoudComp" | Enables dynamic loudness compensation in the decoder. |

In the above example, an interface parameter (e.g., a drcEffectTypeRequest parameter of a dynamicRangeControllerInterface() payload) may be set to the specific value (e.g., 9) that corresponds to the Dynamic Loudness Compensation Effect to instruct the decoder that, if available, a DRC Set which provides the Dynamic Loudness Compensation Effect set should be selected and applied. However, because dynamic loudness compensation may be intended for use in combination with loudness normalization, in some cases a decoder may require that in order to select and apply a DRC set that provides a dynamic loudness compensation effect, a decoder must also perform loudness normalization. Such a requirement could be accomplished by only allowing the decoder to select a DRC set that provides a dynamic loudness compensation effect when loudness normalization is also enabled in the decoder. Alternatively, or in addition, such a requirement could be satisfied by modifying the interface to require that when requesting a DRC set which provides a dynamic loudness compensation effect, loudness normalization must also be enabled (e.g., by setting both a loudness normalization on flag and a target loudness value).

### Specifying DRC Sets with Dynamic Loudness Compensation using new extension payloads

Alternatively, a new payload (e.g, dynLoudInstructions()) including instructions for dynamic loudness compensation could be defined. One or more of such payloads could, e.g., be included in an extension field (e.g., UNIDRCCONFEXT_V2) of an existing bitstream. By including such payloads in an extension field, compatibility with existing decoders that were not designed to parse the new payload could be maintained, as such decoders would simply ignore the additional payload(s). Each of such payloads would be assigned a unique identifier (e.g., drcSetId) which corresponds to a DRC set that provides dynamic loudness compensation, and, to help easily identify such sets, a flag (e.g., a dynamicLoudCompDRCSet flag) could be set to 1 for each such DRC set signaled through the new payload.

Additionally, the user interface described above for selecting DRC sets that provide the dynamic loudness compensation effect could be used for DRC sets signaled through this new type of payload (e.g., dynLoudInstructions() payload) as well. Specifically, a user could indicate to the decoder through the interface (e.g., using the drcEffectTypeRequest field) that a DRC set that provides dynamic loudness compensation is desired. The decoder would then select, if present, a DRC set signaled through the new payloads (e.g., a DRC set having a DRC Set ID that is identified as corresponding to dynamic loudness compensation, and, for instance, having a dynamicLoudCompDRCSet flag set to 1). However, as noted above, because dynamic loudness compensation may be intended for use in combination with loudness normalization, in some cases a decoder may require that in order to select and apply a DRC set that provides a dynamic loudness compensation effect, a decoder must also perform loudness normalization. Such a requirement could be accomplished by only allowing the decoder to select a DRC set that provides a dynamic loudness compensation effect when loudness normalization is also enabled in the decoder. Alternatively, or in addition, such a requirement could be satisfied by modifying the interface to require that when requesting a DRC set which provides a dynamic loudness compensation effect, loudness normalization must also be enabled (e.g., by setting both a loudness normalization on flag and a target loudness value).

An advantage to using this type of signaling (e.g., instead of signaling DRC sets which provide dynamic loudness compensation through an existing parameter, such as a drcSetEffect parameter), is that, as described above, additional parameters indicating whether and how a user can enable and/or disable dynamic loudness compensation can be included in such new payloads. For instance, the new payload may also include a parameter (e.g., a dynamicLoudCompSwOffAllowed parameter) which indicates whether or not switching dynamic loudness compensation off through the user interface is allowed for each DRC set that applies dynamic loudness compensation.

An example syntax for a new payload (e.g., a dynLoudInstructions() payload) for dynamic loudness compensation is shown in the table below.

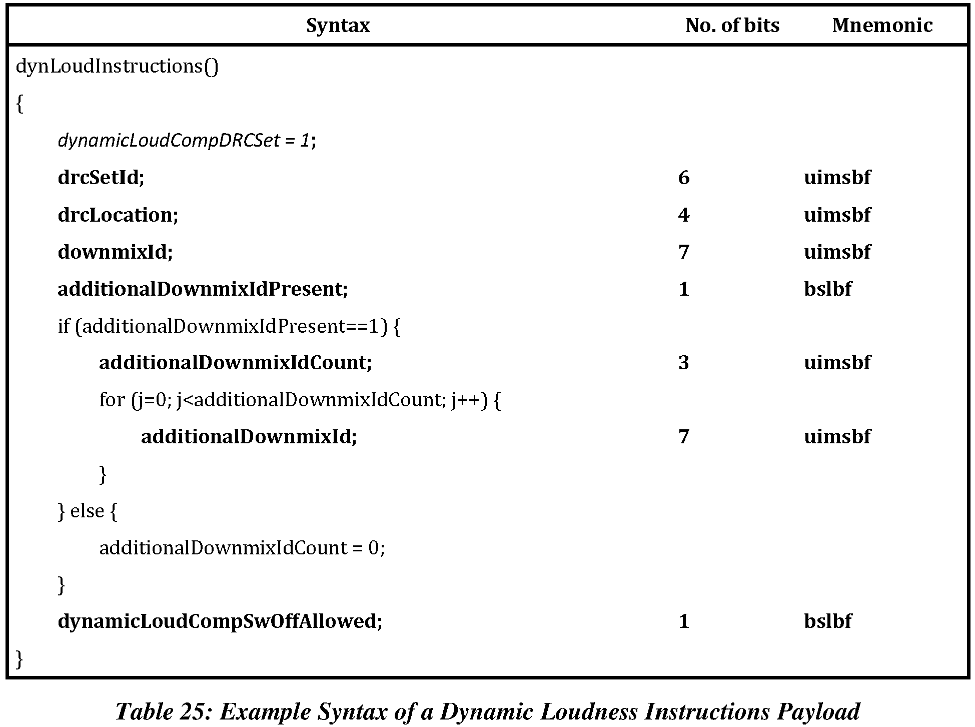

As described above, a unique DRC Set ID, as well as a flag (e.g., dynamicLoudCompDRCSet) which specifically indicates the DRC Set as a DRC set that provides dynamic loudness compensation, may be associated with the payload. Furthermore, the payload may be associated with one or more downmix identification parameters (e.g., downmixId parameters) which indicate that the DRC set is intended for use with one or more specific downmixes / downmix configurations of the audio program. Such DRC Set identifier (e.g., drcSetId parameter), as well as the flag (e.g., dynamicLoudCompDRCSet flag) allow for selection of the DRC Set associated with the payload in response to a user indication, provided through an interface, that a dynamic loudness compensation DRC effect is desired by the user. Additionally, the inclusion of one or more downmix identifiers (e.g., downmixID parameters) enables the selection of a DRC set that provides dynamic loudness compensation which is intended for use with a particular downmix or downmixes of the audio program. Finally, as also described above, the inclusion of a parameter (e.g., dynamicLoudComSwOffAllowed) indicating whether or not turning off dynamic loudness compensation is allowed, enables a content creator additional control over whether or not dynamic loudness compensation may be applied by decoders.

Finally, as indicated above, such additional payloads (e.g., dynLoudInstructions() payloads) may be contained in an extension payload of a configuration payload (e.g., a uniDrcConfigExtension() payload). A specific extension type (e.g., a uniDrcConfigExtType of UNIDRCCONFEXT_V2 having a value of 0x2) may be used to indicate the presence of such additional payloads within the extension field of the configuration payload.

An example of a syntax for an extension field of a configuration payload (e.g., a uniDrcConfigExtension() payload) is shown in the table below.

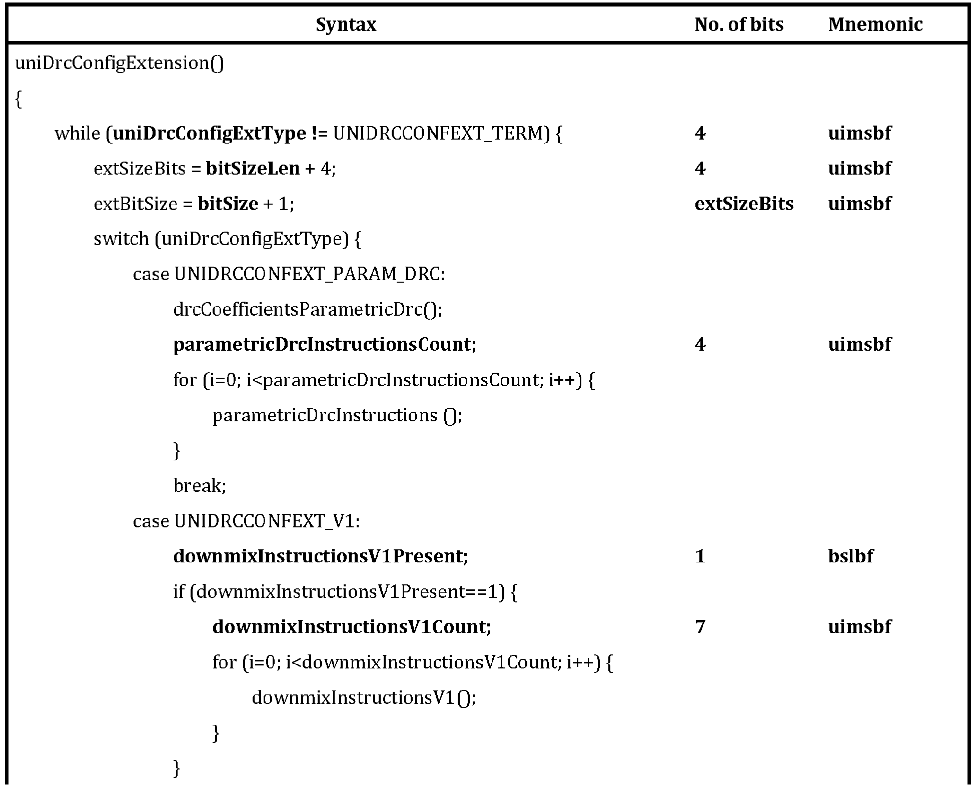

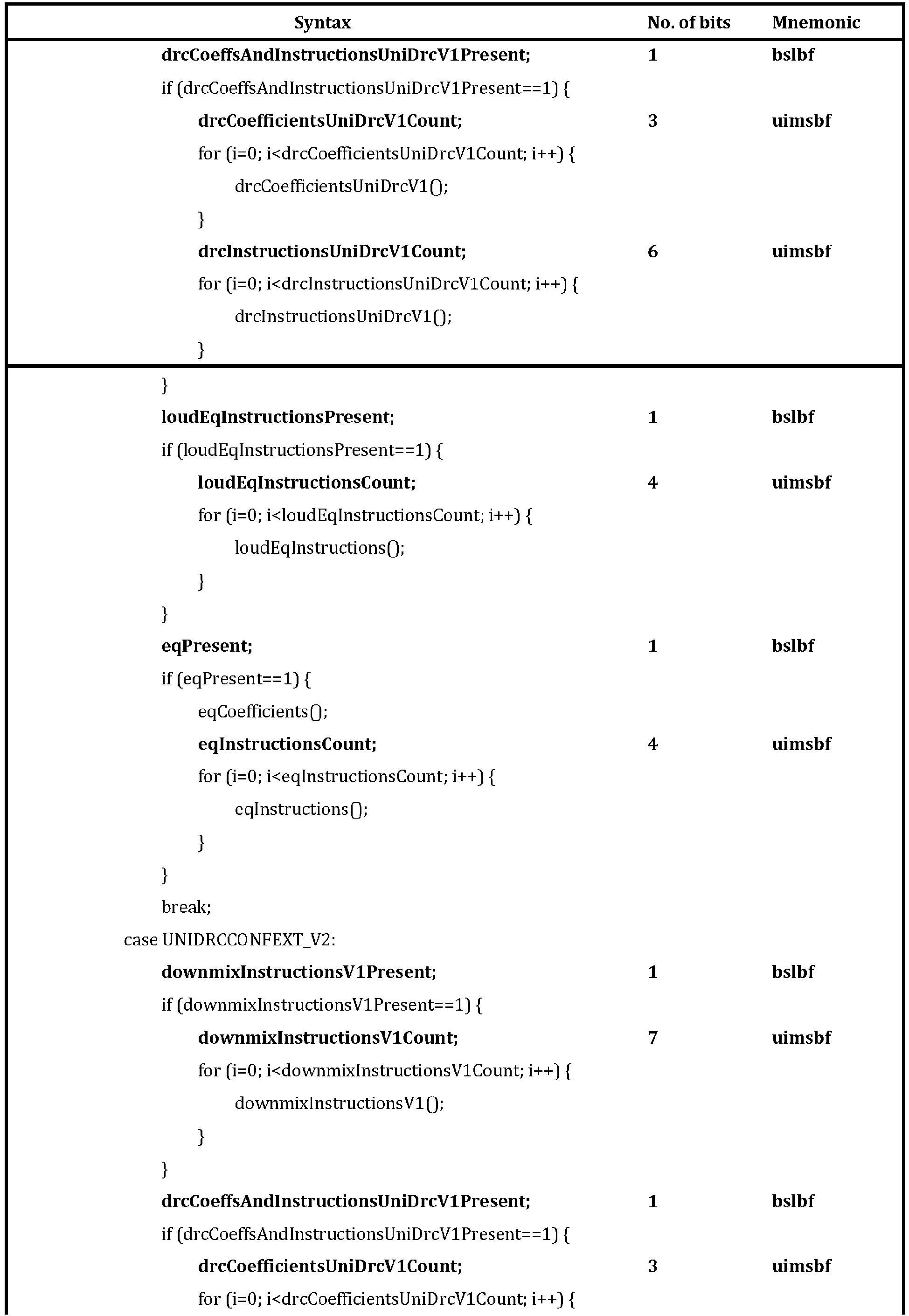

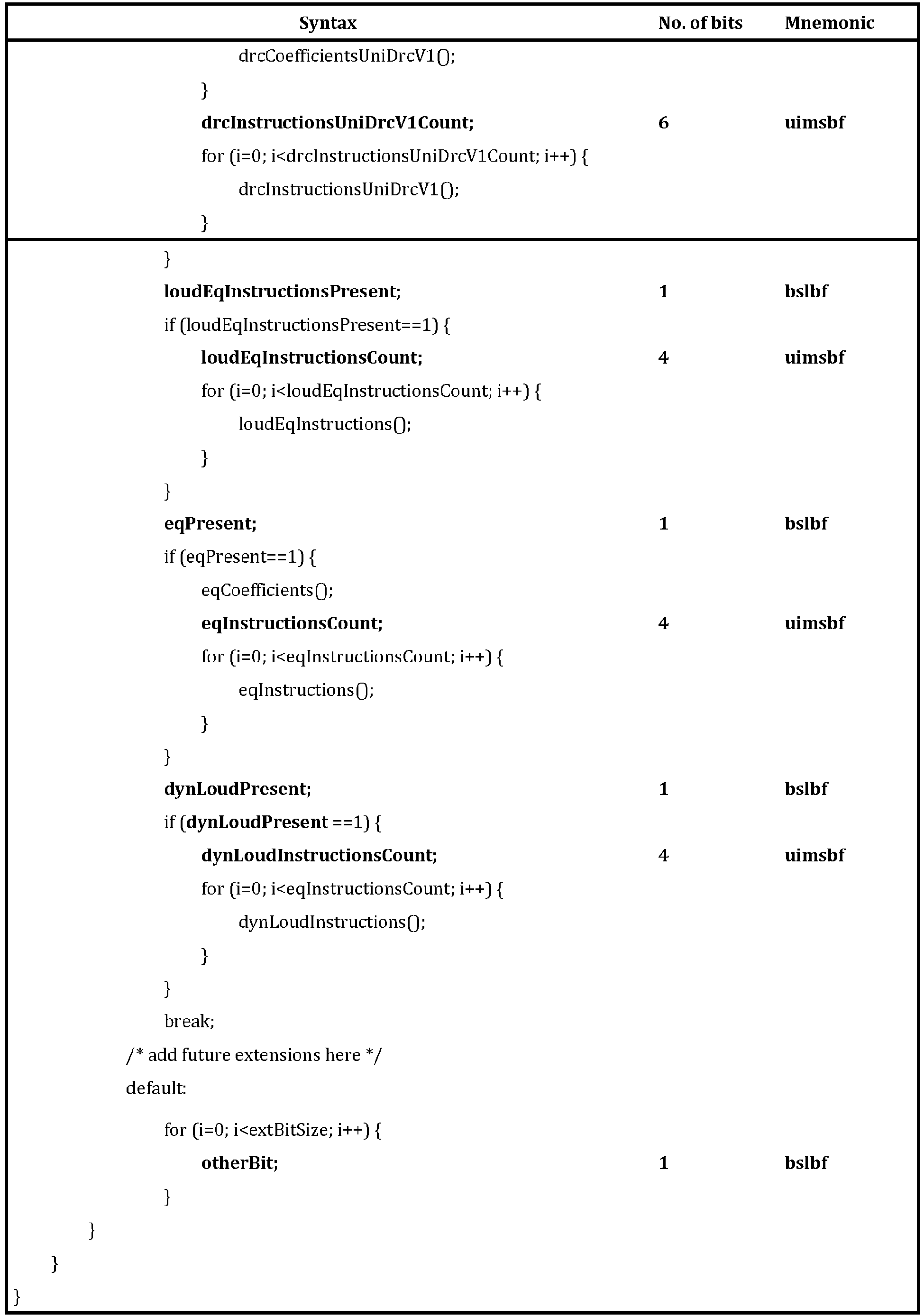

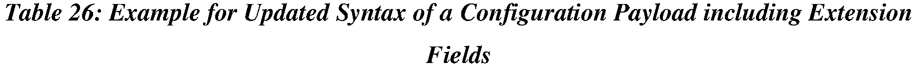

The data associated with the specific extension type of the extension field of the configuration payload contains a parameter which indicates whether dynamic loudness compensation instructions are present (e.g., a dynLoudPresent parameter), and if so, a parameter which indicates the number of sets of dynamic loudness compensation instructions in the extension payload (e.g., a dynLoudInstructionsCount parameter), and each set of dynamic loudness compensation instructions (e.g., each dynLoudInstructions() payload), where the syntax for the dynamic loudness compensation instructions may be as shown in the table above.

### Signaling DRC Sets for Dynamic Loudness Compensation through existing configuration elements

Still alternatively, it may be possible to indicate that a particular DRC set provides dynamic loudness compensation by adding a new field to an existing configuration element. For example, a new parameter (e.g., a dynamicLoudCompDRCSet parameter) that indicates whether or not a DRC set provides dynamic loudness compensation could be included in an existing configuration element (e.g., in a downmixInstructions() element, a drcInstructionsBasic() element, or a drcInstructionsUniDrc() element). Ideally, to avoid compatibility issues with legacy decoders, the new element could be included in a field which is already ignored by legacy decoders (e.g., in a reserved field). Alternatively, the new parameter could be included in an updated version of an existing configuration element (e.g., in a downmixInstructionsV2() element or a drcInstructionsUniDrcV2() element), which would be ignored by legacy decoders.

Finally, similarly to the selection process described above, DRC Sets that are signaled as providing dynamic loudness compensation in this manner could be selected through an interface to the decoder by indicating that a DRC Set is desired that provides a dynamic loudness compensation effect. When such indication is provided through the interface to the decoder, the decoder will identify and select a DRC Set which is indicated as providing dynamic loudness compensation (e.g., which has a dynamicLoudCompDRCSet parameter that equals 1). If multiple DRC sets are indicated as providing dynamic loudness compensation, a decoder may use other rules (e.g., predefined rules, such as those defined in ISO/IEC 23003-4:2020) for selecting the most appropriate DRC set of the multiple DRC sets that provide dynamic loudness compensation.

However, because dynamic loudness compensation may be intended for use in combination with loudness normalization, in some cases a decoder may require that in order to select and apply a DRC set that provides a dynamic loudness compensation effect, a decoder must also perform loudness normalization. Such a requirement could be accomplished by only allowing the decoder to select a DRC set that provides a dynamic loudness compensation effect when loudness normalization is also enabled in the decoder. Alternatively, or in addition, such a requirement could be satisfied by modifying the interface to require that when requesting a DRC set which provides a dynamic loudness compensation effect, loudness normalization must also be enabled (e.g., by setting both a loudness normalization on flag and a target loudness value).

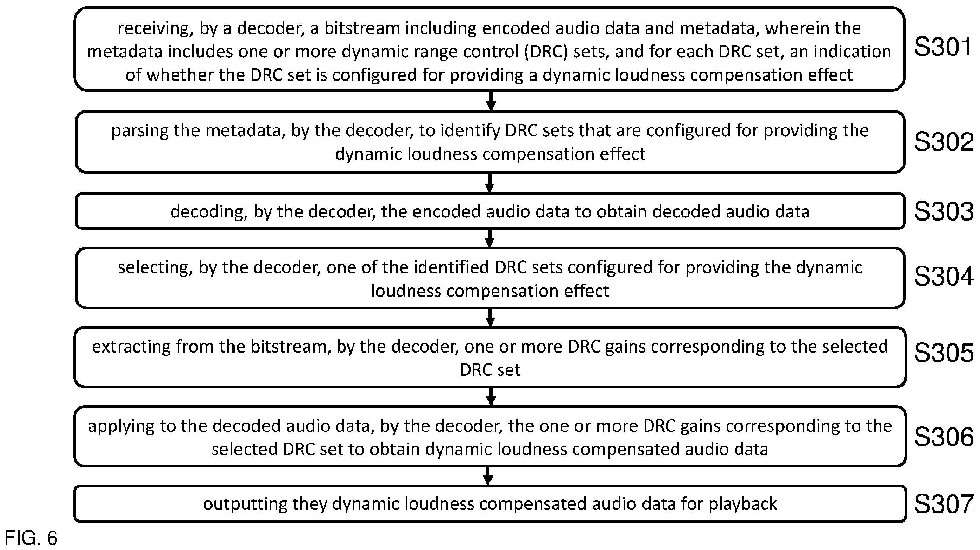

Figure 6 illustrates an example method of processing audio data for playback as described above. Referring to the example of Figure 6, in step S301 the decoder 100 may receive a bitstream including encoded audio data and metadata, wherein the metadata includes one or more dynamic range control (DRC) sets, and for each DRC set, an indication of whether the DRC set is configured for providing a dynamic loudness compensation effect, e.g., as described above.

While the format of the bitstream is not limited, in an embodiment, the bitstream may be an MPEG-D DRC bitstream. The presence of metadata for providing a dynamic loudness compensation effect may then be signaled based on MPEG-D DRC bitstream syntax, e.g., as described above.

In step S302, the decoder may then parse the metadata to identify DRC sets that are configured for providing the dynamic loudness compensation effect, e.g., as described above.

In step S303, the decoder may then decode the audio data to obtain decoded audio data, e.g., as described above.

In step S304, the decoder may then select one of the identified DRC sets configured for providing the dynamic loudness compensation effect, e.g., as described above.

In step S305, the decoder may then extract one or more DRC gains corresponding to the selected DRC set from the bitstream, e.g., as described above.

In step S306, the decoder may then apply the one or more DRC gains corresponding to the selected DRC set to the decoded audio data to obtain dynamic loudness compensated audio data, e.g., as described above.

Finally, in step S307, the dynamic loudness compensated audio data may then be output for playback, e.g., as described above.

### Efficient Coding / Transmission of Dynamic Loudness Compensation Data

As described above, dynamic loudness compensation, in combination with dynamic range control, may be achieved by transmitting a DRC set that contains gains which are a combination of dynamic range control gains and dynamic loudness compensation gains. However, doing so may require redundant transmission of dynamic range control gain data. For instance, a first DRC set may contain gains for applying dynamic range control to a signal, and it may be important to allow for that DRC gain set to be applied independently of any other gains (e.g., dynamic loudness compensation gains). Therefore, if a DRC set is desired which contains gains for applying a combination of dynamic range control and dynamic loudness compensation, then a second DRC set needs to be specified which represents a combination of the dynamic range control gains of the first set and the desired dynamic loudness compensation gains. Unfortunately, doing so requires that both the first and the second DRC sets contain information about the dynamic range control gains of the first set, which is inefficient.

A more efficient way of transmitting data to accomplish the same goal is to provide only the dynamic range control gains in a first DRC set, and only the dynamic loudness compensation gains in a second DRC set, along with some additional metadata indicating the relationship between the two DRC sets. For instance, the first DRC set may include a parameter which indicates that there is another DRC set which depends on the first DRCset. Then, a decoder may understand that it is possible to apply the gains of the first set independently, e.g., in case only dynamic range control is desired. Additionally, the decoder will understand that it is also possible to combine the gains of the first and second DRC sets in order to obtain a combination of dynamic range control and dynamic loudness compensation. Finally, in cases where the gains of the second set are never intended to be applied alone, metadata can be included with the second DRC set to indicate whether the gains of that DRC set may only be used in conjunction with the first set, or whether they may be used independently of the gains of the first set.

For example, consider 2 DRC sets, with a first DRC set identified as DRC Set 1 (e.g., has a drcSetId equal to 1) providing gains for dynamic range control, and a second DRC Set identified as DRC Set 2 (e.g., has a drcSetId equal to 2) providing gains for dynamic loudness compensation. Since DRC Set 2 is intended for use in combination with DRC Set 1, DRC Set 1 could include a parameter indicating that DRC Set 2 depends on DRC Set 1 (e.g., a dependsOnDrcSet parameter of DRC Set 1 may be equal to 2). Furthermore, if dynamic loudness compensation is only intended for use in combination with dynamic range control, then DRC Set 2 could include a parameter indicating that the gains of DRC Set 2 may not be used independently (e.g., a noIndependentUse flag of DRC Set 2 may be set to a value 1). Conversely, if DRC Set 2 was not intended only for use in combination with dynamic range control, then DRC Set 2 could include a parameter indicating that the gains of DRC Set 2 may be used independently (e.g., a noIndependentUse flag of DRC Set 2 may be set to a value of 0).

The above described Efficient Coding/Transmission of Dynamic Loudness Compensation data may be used with any of the above described Additional Methods of Enabling Dynamic Loudness Compensation.

For instance, in the first case, where the presence of a DRC Set which provides a dynamic loudness compensation effect is signaled through an existing effect flag (e.g., a bit of a drcSetEffect bitfield), DRC Set 1 could have a drcSetEffect parameter in which the bit corresponding to the dynamic loudness compensation effect is set to 0, while DRC Set 2 could have the bit corresponding to the dynamic loudness compensation effect set to 1, and all other bits of the bitfield may be the same for both DRC Sets. Through such signaling, when a user requests a dynamic loudness compensation effect through the interface, a decoder will extract and apply the gains of DRC Set 1 and DRC Set 2 in order to apply a combination of dynamic range control and dynamic loudness compensation.

The following table shows exemplary values of parameters accomplishing the above signaling of efficient transmission of dynamic loudness compensation data.

**Table 27: Exemplary Values of parameters for signaling efficient transmission of dynamic loudness compensation data**

| ***Parameter*** | ***DRC Set 1*** | ***DRC Set 2*** |
|---|---|---|
| *drcSetID (Example)* | 0x01 | 0x02 |
| *dependsOnDrcSet* | 0x02 | Not set |
| *noIndependentUse* | 0 | 1 |
| *drcSetEffect* | "Dynamic compensation flag" set to 0, otherwise same. | "Dynamic compensation flag" set to 1, otherwise same. |

In the second case, where the presence of a DRC Set which provides a dynamic loudness compensation effect is signaled using a new payload, DRC Set 2 would be signaled through the new payload (e.g., the drcSetId parameter of the dynLoudInstructions payload would be set to 2). DRC Set 1 would be signaled as described above (e.g., a drcSetId parameter would be set to 1, and a dependsonDrcSet parameter would be set to 2, indicating that DRC Set 2 depends on DRC Set 1). Finally, it would not be possible to indicate through the new payload described above (e.g., dynLoudInstructions) that DRC Set 2 should not be used independently (e.g., that it should always be used with DRC Set 1). As such, an additional parameter could be added to the new payload (e.g., a noIndependentUse parameter could be added to the dynLoudInstructions payload), such that, when the new parameter is set to 1, DRC Set 2 is only used with DRC Set 1, while when the new parameter is set to 0, DRC Set 2 may be used independently of DRC Set 1. Similarly to the first case, when a user requests a dynamic loudness compensation effect through the interface, a decoder will extract and apply the gains of both DRC Set 1 and DRC Set 2 in order to apply a combination of dynamic range control and dynamic loudness compensation.

Finally, in the third case, existing configuration elements are used which already include all of the necessary parameters for efficiently enabling dynamic loudness compensation as described above. Specifically, DRC Set 1 would include an indication that DRC Set 2 depends on DRC Set 1 as described above, and DRC Set 2 would include an indication of whether or not it may be used independently, or only in conjunction with DRC Set 2. Again, similarly to the first two cases, when a user requests a dynamic loudness compensation effect through the interface, a decoder will extract and apply the gains of DRC Set 1 and DRC Set 2 in order to apply a combination of dynamic range control and dynamic loudness compensation.

As indicated above, a benefit of using dependent DRC Sets to enable dynamic loudness compensation is that doing so allows for more efficient transmission of the data required for dynamic loudness compensation, because it is eliminates the need to transmit redundant dynamic range control gains in the DRC Set which contains the dynamic loudness compensation gains.

### Interpretation

Unless specifically stated otherwise, as apparent from the following discussions, it is appreciated that throughout the disclosure discussions utilizing terms such as "processing", "computing", "determining", "analyzing" or the like, refer to the action and/or processes of a computer or computing system, or similar electronic computing devices, that manipulate and/or transform data represented as physical, such as electronic, quantities into other data similarly represented as physical quantities.

In a similar manner, the term "processor" may refer to any device or portion of a device that processes electronic data, e.g., from registers and/or memory to transform that electronic data into other electronic data that, e.g., may be stored in registers and/or memory. A "computer" or a "computing machine" or a "computing platform" may include one or more processors.

The methodologies described herein are, in one example embodiment, performable by one or more processors that accept computer-readable (also called machine-readable) code containing a set of instructions that when executed by one or more of the processors carry out at least one of the methods described herein. Any processor capable of executing a set of instructions (sequential or otherwise) that specify actions to be taken are included. Thus, one example is a typical processing system that includes one or more processors. Each processor may include one or more of a CPU, a graphics processing unit, and a programmable DSP unit. The processing system further may include a memory subsystem including main RAM and/or a static RAM, and/or ROM. A bus subsystem may be included for communicating between the components. The processing system further may be a distributed processing system with processors coupled by a network. If the processing system requires a display, such a display may be included, e.g., a liquid crystal display (LCD) or a cathode ray tube (CRT) display. If manual data entry is required, the processing system also includes an input device such as one or more of an alphanumeric input unit such as a keyboard, a pointing control device such as a mouse, and so forth. The processing system may also encompass a storage system such as a disk drive unit. The processing system in some configurations may include a sound output device, and a network interface device. The memory subsystem thus includes a computer-readable carrier medium that carries computer-readable code (e.g., software) including a set of instructions to cause performing, when executed by one or more processors, one or more of the methods described herein. Note that when the method includes several elements, e.g., several steps, no ordering of such elements is implied, unless specifically stated. The software may reside in the hard disk, or may also reside, completely or at least partially, within the RAM and/or within the processor during execution thereof by the computer system. Thus, the memory and the processor also constitute computer-readable carrier medium carrying computer-readable code. Furthermore, a computer-readable carrier medium may form, or be included in a computer program product.

In alternative example embodiments, the one or more processors operate as a standalone device or may be connected, e.g., networked to other processor(s), in a networked deployment, the one or more processors may operate in the capacity of a server or a user machine in server-user network environment, or as a peer machine in a peer-to-peer or distributed network environment. The one or more processors may form a personal computer (PC), a tablet PC, a Personal Digital Assistant (PDA), a cellular telephone, a web appliance, a network router, switch or bridge, or any machine capable of executing a set of instructions (sequential or otherwise) that specify actions to be taken by that machine.

Note that the term "machine" shall also be taken to include any collection of machines that individually or jointly execute a set (or multiple sets) of instructions to perform any one or more of the methodologies discussed herein.

Thus, one example embodiment of each of the methods described herein is in the form of a computer-readable carrier medium carrying a set of instructions, e.g., a computer program that is for execution on one or more processors, e.g., one or more processors that are part of web server arrangement. Thus, as will be appreciated by those skilled in the art, example embodiments of the present disclosure may be embodied as a method, an apparatus such as a special purpose apparatus, an apparatus such as a data processing system, or a computer-readable carrier medium, e.g., a computer program product. The computer-readable carrier medium carries computer readable code including a set of instructions that when executed on one or more processors cause the processor or processors to implement a method. Accordingly, aspects of the present disclosure may take the form of a method, an entirely hardware example embodiment, an entirely software example embodiment or an example embodiment combining software and hardware aspects. Furthermore, the present disclosure may take the form of carrier medium (e.g., a computer program product on a computer-readable storage medium) carrying computer-readable program code embodied in the medium.

The software may further be transmitted or received over a network via a network interface device. While the carrier medium is in an example embodiment a single medium, the term "carrier medium" should be taken to include a single medium or multiple media (e.g., a centralized or distributed database, and/or associated caches and servers) that store the one or more sets of instructions. The term "carrier medium" shall also be taken to include any medium that is capable of storing, encoding or carrying a set of instructions for execution by one or more of the processors and that cause the one or more processors to perform any one or more of the methodologies of the present disclosure. A carrier medium may take many forms, including but not limited to, non-volatile media, volatile media, and transmission media. Non-volatile media includes, for example, optical, magnetic disks, and magneto-optical disks. Volatile media includes dynamic memory, such as main memory. Transmission media includes coaxial cables, copper wire and fiber optics, including the wires that comprise a bus subsystem. Transmission media may also take the form of acoustic or light waves, such as those generated during radio wave and infrared data communications. For example, the term "carrier medium" shall accordingly be taken to include, but not be limited to, solid-state memories, a computer product embodied in optical and magnetic media; a medium bearing a propagated signal detectable by at least one processor or one or more processors and representing a set of instructions that, when executed, implement a method; and a transmission medium in a network bearing a propagated signal detectable by at least one processor of the one or more processors and representing the set of instructions.

It will be understood that the steps of methods discussed are performed in one example embodiment by an appropriate processor (or processors) of a processing (e.g., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

Reference throughout this disclosure to "one embodiment", "some embodiments" or "an example embodiment" means that a particular feature, structure or characteristic described in connection with the embodiment is included in at least one embodiment of the present disclosure. Thus, appearances of the phrases "in one embodiment", "in some embodiments" or "in an example embodiment" in various places throughout this disclosure are not necessarily all referring to the same example embodiment. Furthermore, the particular features, structures or characteristics may be combined in any suitable manner, as would be apparent to one of ordinary skill in the art from this disclosure, in one or more example embodiments.

As used herein, unless otherwise specified the use of the ordinal adjectives "first", "second", "third", etc., to describe a common object, merely indicate that different instances of like objects are being referred to and are not intended to imply that the objects so described must be in a given sequence, either temporally, spatially, in ranking, or in any other manner.

In the claims below and the description herein, any one of the terms comprising, comprised of or which comprises is an open term that means including at least the elements/features that follow, but not excluding others. Thus, the term comprising, when used in the claims, should not be interpreted as being limitative to the means or elements or steps listed thereafter. For example, the scope of the expression a device comprising A and B should not be limited to devices consisting only of elements A and B. Any one of the terms including or which includes or that includes as used herein is also an open term that also means including at least the elements/features that follow the term, but not excluding others. Thus, including is synonymous with and means comprising.

It should be appreciated that in the above description of example embodiments of the disclosure, various features of the disclosure are sometimes grouped together in a single example embodiment, Fig., or description thereof for the purpose of streamlining the disclosure and aiding in the understanding of one or more of the various inventive aspects. This method of disclosure, however, is not to be interpreted as reflecting an intention that the claims require more features than are expressly recited in each claim. Rather, as the following claims reflect, inventive aspects lie in less than all features of a single foregoing disclosed example embodiment.

Furthermore, while some example embodiments described herein include some but not other features included in other example embodiments, combinations of features of different example embodiments are meant to be within the scope of the disclosure, and form different example embodiments, as would be understood by those skilled in the art. For example, in the following claims, any of the claimed example embodiments can be used in any combination.

In the description provided herein, numerous specific details are set forth. However, it is understood that example embodiments of the disclosure may be practiced without these specific details. In other instances, well-known methods, structures and techniques have not been shown in detail in order not to obscure an understanding of this description.

## Claims

1. A method of processing audio data for playback, the method including:
receiving (S301), by a decoder, a bitstream including encoded audio data and metadata, wherein the metadata includes one or more dynamic range control (DRC) sets, and for each DRC set, an indication of whether the DRC set is configured for providing a dynamic loudness compensation effect;
parsing (S302) the metadata, by the decoder, to identify DRC sets that are configured for providing the dynamic loudness compensation effect;
decoding (S303), by the decoder, the encoded audio data to obtain decoded audio data;
selecting (S304), by the decoder, one of the identified DRC sets configured for providing the dynamic loudness compensation effect;
extracting (S305) from the bitstream, by the decoder, one or more DRC gains corresponding to the selected DRC set;
applying (S306) to the decoded audio data, by the decoder, the one or more DRC gains corresponding to the selected DRC set to obtain dynamic loudness compensated audio data; and
outputting (S307) the dynamic loudness compensated audio data for playback;
wherein a first one of the DRC sets is configured for providing dynamic range control, and wherein the first DRC set comprises an indication that the selected DRC set configured for providing the dynamic loudness compensation effect is configured for application in combination with the first DRC set.

2. The method according to claim 1, wherein the indication of whether the DRC set is configured for providing the dynamic loudness compensation effect is whether the DRC set is specified in a dynamic loudness compensation bitstream payload.

3. The method according to claim 2, wherein the dynamic loudness compensation bitstream payload is included in an extension field of a previously defined bitstream syntax, wherein the extension field is optionally a uniDrcConfigExtension field of an MPEG-D DRC bitstream, and wherein the dynamic loudness compensation bitstream payload is included only for specific values of a uniDrcConfigExtType parameter.

4. The method according to claim 3, wherein a plurality of dynamic loudness compensation payloads specifying a plurality of DRC sets configured for providing the dynamic loudness compensation effect are included in the extension field of the previously defined bitstream syntax.

5. The method of claim 1, wherein the indication of whether the DRC set is configured for providing the dynamic loudness compensation effect is a field of a previously existing configuration element of a previously defined bitstream syntax.

6. The method of claim 5, wherein the field is a dynamicLoudCompDRCSet parameter, and the previously existing configuration element is a downmixInstructions element, a drcInstructionsBasic element, or a drcInstructionsUniDRC element of an MPEG-D DRC bitstream, wherein the field is optionally a previously existing field reserved for future use.

7. The method of claim 1, wherein the indication of whether the DRC set is configured for providing the dynamic loudness compensation effect is a field of an updated version of a previously existing configuration element of a previously defined bitstream syntax.

8. The method of claim 7, wherein the field is a dynamicLoudCompDRCSet parameter, and the updated version of the previously existing configuration element is a downmixInstructionsV2 element or a drcInstructions UniDrc V2 element.

9. The method of any one of claims 1 to 8, wherein an indication that a dynamic loudness compensation effect is desired is provided to the decoder through an interface, and wherein the DRC set is selected in response to the indication provided to the decoder through the interface

10. The method of claim 9, wherein indications of additional desired effects are provided to the decoder through the interface, wherein the metadata includes a plurality of DRC sets configured to provide the dynamic loudness compensation effect, and wherein the selection depends on the additional desired effects.

11. The method of claim 9 or 10, wherein the indication that a dynamic loudness compensation effect is desired is provided through a drcEffectTypeRequest parameter of a dynamicRangeControllerInterface payload.

12. A decoder for processing audio data for playback, wherein the decoder comprises one or more processors and non-transitory memory configured to perform the method of any one of claims 1 to 11.

13. A computer program product comprising a computer-readable storage medium with instructions adapted to cause a device to carry out the method according to any one of claims 1 to 11.

14. A computer-readable storage medium storing the computer program product of claim 13.

## Patentansprüche

1. Verfahren zur Verarbeitung von Audiodaten für die Wiedergabe, wobei das Verfahren Folgendes beinhaltet:
Empfangen (S301) eines Bitstroms durch einen Decoder, der codierte Audiodaten und Metadaten beinhaltet, wobei die Metadaten einen oder mehrere Dynamic Range Control (DRC)-Sätze und für jeden DRC-Satz eine Angabe darüber beinhalten, ob der DRC-Satz zum Bereitstellen eines dynamischen Lautstärkeabgleicheffekts konfiguriert ist;
Analysieren (S302) der Metadaten durch den Decoder, um DRC-Sätze zu identifizieren, die zum Bereitstellen des dynamischen Lautstärkeabgleicheffekts konfiguriert sind;
Dekodieren (S303) durch den Decoder, der kodierten Audiodaten, um dekodierte Audiodaten zu erhalten;
Auswählen (S304) durch den Decoder eines der identifizierten DRC-Sätze, die zum Bereitstellen des dynamischen Lautstärkeabgleicheffekts konfiguriert sind;
Extrahieren (S305) aus dem Bitstrom durch den Decoder einer oder mehrerer DRC-Verstärkungen, die dem ausgewählten DRC-Satz entsprechen;
Anwenden (S306) der einen oder mehreren DRC-Verstärkungen, die dem ausgewählten DRC-Satz entsprechen, auf die dekodierten Audiodaten durch den Decoder, um dynamische lautstärkenabgeglichene Audiodaten zu erhalten; und
Ausgeben (S307) der dynamischen lautstärkenabgeglichenen Audiodaten zur Wiedergabe;
wobei ein erster der DRC-Sätze zum Bereitstellen einer Dynamikbereichssteuerung konfiguriert ist und wobei der erste DRC-Satz eine Angabe umfasst, dass der ausgewählte DRC-Satz, der zum Bereitstellen des dynamischen Lautstärkeabgleicheffekts konfiguriert ist, zur Anwendung in Kombination mit dem ersten DRC-Satz konfiguriert ist.

2. Verfahren nach Anspruch 1, wobei die Angabe, ob der DRC-Satz zum Bereitstellen des dynamischen Lautstärkeabgleicheffekts konfiguriert ist, darin besteht, ob der DRC-Satz in einer dynamischen Lautstärkeabgleichs-Bitstream-Nutzlast spezifiziert ist.

3. Verfahren nach Anspruch 2, wobei die dynamische Lautstärkeabgleichs-Bitstream-Nutzlast in einem Erweiterungsfeld einer zuvor definierten Bitstream-Syntax beinhaltet ist, wobei das Erweiterungsfeld optional ein UniDrcConfigExtension-Feld eines MPEG-D DRC-Bitstreams ist und wobei die dynamische Lautstärkeabgleichs-Bitstream-Nutzlast nur für bestimmte Werte eines UniDrcConfigExtType-Parameters beinhaltet ist.

4. Verfahren nach Anspruch 3, wobei eine Vielzahl von dynamischen Lautstärkeabgleichs-Bitstream-Nutzlasten, die eine Vielzahl von DRC-Sätzen spezifizieren, die zum Bereitstellen des dynamischen Lautstärkeabgleicheffekts konfiguriert sind, im Erweiterungsfeld der zuvor definierten Bitstream-Syntax beinhaltet ist.

5. Verfahren nach Anspruch 1, wobei die Angabe, ob der DRC-Satz zum Bereitstellen des dynamischen Lautstärkeabgleicheffekts konfiguriert ist, ein Feld eines zuvor vorhandenen Konfigurationselements einer zuvor definierten Bitstream-Syntax ist.

6. Verfahren nach Anspruch 5, wobei es sich bei dem Feld um einen dynamicLoudCompDRCSet-Parameter handelt und das zuvor vorhandene Konfigurationselement ein downmixlnstructions-Element, ein drclnstructionsBasic-Element oder ein drclnstructionsUniDRC-Element eines MPEG-D DRC-Bitstroms ist, wobei es sich bei dem Feld optional um ein zuvor vorhandenes Feld handelt, das für eine zukünftige Verwendung reserviert ist.

7. Verfahren nach Anspruch 1, wobei die Angabe, ob der DRC-Satz zum Bereitstellen des dynamischen Lautstärkeabgleicheffekts konfiguriert ist, ein Feld einer aktualisierten Version eines zuvor vorhandenen Konfigurationselements einer zuvor definierten Bitstream-Syntax ist.

8. Verfahren nach Anspruch 7, wobei es sich bei dem Feld um einen dynamicLoudCompDRCSet-Parameter handelt und die aktualisierte Version des zuvor vorhandenen Konfigurationselements ein downmixInstructionsV2-Element oder ein drclnstructionsUniDrcV2-Element ist.

9. Verfahren nach einem der Ansprüche 1 bis 8, wobei eine Angabe, dass ein dynamischer Lautstärkeabgleicheffekt gewünscht ist, dem Decoder über eine Schnittstelle bereitgestellt wird und wobei der DRC-Satz in Reaktion auf die über die Schnittstelle dem Decoder bereitgestellte Angabe ausgewählt wird.

10. Verfahren nach Anspruch 9, wobei Angaben zu zusätzlich gewünschten Effekten dem Decoder über die Schnittstelle bereitgestellt werden, wobei die Metadaten eine Vielzahl von DRC-Sätzen beinhalten, die so konfiguriert sind, dass sie den Effekt der dynamischen Lautstärkeabgleich bereitstellen, und wobei die Auswahl von den zusätzlichen gewünschten Effekten abhängt.

11. Verfahren nach Anspruch 9 oder 10, wobei die Angabe, dass ein dynamischer Lautstärkeabgleicheffekt gewünscht ist, über einen drcEffectTypeRequest-Parameter einer dynamicRangeControllerlnterface-Nutzlast bereitgestellt wird.

12. Decoder zur Verarbeitung von Audiodaten für die Wiedergabe, wobei der Decoder einen oder mehrere Prozessoren und einen nichtflüchtigen Speicher umfasst, die so konfiguriert sind, dass sie das Verfahren nach einem der Ansprüche 1 bis 11 durchführen.

13. Computerprogrammprodukt, umfassend ein computerlesbares Speichermedium mit Anweisungen, die dazu ausgelegt sind, eine Vorrichtung zu veranlassen, das Verfahren nach einem der Ansprüche 1 bis 11 auszuführen.

14. Computerlesbares Speichermedium, das das Computerprogrammprodukt nach Anspruch 13 speichert.

## Revendications

1. Procédé de traitement de données audio en vue de leur lecture, le procédé incluant :
la réception (S301), par un décodeur, d'un flux binaire incluant des données audio encodées et des métadonnées, dans lequel les métadonnées incluent un ou plusieurs ensembles de commande de plage dynamique (DRC) et, pour chaque ensemble DRC, une indication indiquant si l'ensemble DRC est configuré pour fournir un effet de compensation de sonie dynamique ;
l'analyse (S302) des métadonnées, par le décodeur, pour identifier des ensembles DRC configurés pour fournir l'effet de compensation de sonie dynamique ;
le décodage (S303), par le décodeur, des données audio encodées pour obtenir des données audio décodées ;
la sélection (S304), par le décodeur, de l'un des ensembles DRC identifiés configurés pour fournir l'effet de compensation de sonie dynamique ;
l'extraction (S305), à partir du flux binaire, par le décodeur, d'un ou plusieurs gains DRC correspondant à l'ensemble DRC sélectionné ;
l'application (S306), aux données audio décodées, par le décodeur, des un ou plusieurs gains DRC correspondant à l'ensemble DRC sélectionné pour obtenir des données audio à compensation de sonie dynamique ; et
la délivrance (S307) des données audio à compensation de sonie dynamique pour la lecture ;
dans lequel un premier des ensembles DRC est configuré pour assurer une commande de plage dynamique, et dans lequel le premier ensemble DRC comprend une indication indiquant que l'ensemble DRC sélectionné, configuré pour fournir l'effet de compensation de sonie dynamique, est configuré pour être appliqué en combinaison avec le premier ensemble DRC.

2. Procédé selon la revendication 1, dans lequel l'indication indiquant si l'ensemble DRC est configuré pour fournir l'effet de compensation de sonie dynamique indique si l'ensemble DRC est spécifié dans une charge utile de flux binaire de compensation de sonie dynamique.

3. Procédé selon la revendication 2, dans lequel la charge utile de flux binaire de compensation de sonie dynamique est incluse dans un champ d'extension d'une syntaxe de flux binaire précédemment définie, dans lequel le champ d'extension est éventuellement un champ UniDrcConfigExtension d'un flux binaire MPEG-D DRC, et dans lequel la charge utile de flux binaire de compensation de sonie dynamique n'est incluse que pour des valeurs spécifiques d'un paramètre UniDrcConfigExtType.

4. Procédé selon la revendication 3, dans lequel une pluralité de charges utiles de compensation de sonie dynamique spécifiant une pluralité d'ensembles DRC configurés pour fournir l'effet de compensation de sonie dynamique sont incluses dans le champ d'extension de la syntaxe de flux binaire précédemment définie.

5. Procédé selon la revendication 1, dans lequel l'indication indiquant si l'ensemble DRC est configuré pour fournir l'effet de compensation de sonie dynamique est un champ d'un élément de configuration précédemment existant d'une syntaxe de flux binaire précédemment définie.

6. Procédé selon la revendication 5, dans lequel le champ est un paramètre dynamicLoudCompDRCSet, et l'élément de configuration précédemment existant est un élément downmixlnstructions, un élément drclnstructionsBasic ou un élément drclnstructionsUniDRC d'un flux binaire MPEG-D DRC, dans lequel le champ est éventuellement un champ précédemment existant réservé pour une utilisation future.

7. Procédé selon la revendication 1, dans lequel l'indication indiquant si l'ensemble DRC est configuré pour fournir l'effet de compensation de sonie dynamique est un champ d'une version mise à jour d'un élément de configuration précédemment existant d'une syntaxe de flux binaire précédemment définie.

8. Procédé selon la revendication 7, dans lequel le champ est un paramètre dynamicLoudCompDRCSet, et la version mise à jour de l'élément de configuration précédemment existant est un élément downmixInstructionsV2 ou un élément drcInstructionsUniDrcV2.

9. Procédé selon l'une quelconque des revendications 1 à 8, dans lequel une indication qu'un effet de compensation de sonie dynamique est souhaité est fournie au décodeur via une interface, et dans lequel l'ensemble DRC est sélectionné en réponse à l'indication fournie au décodeur via l'interface.

10. Procédé selon la revendication 9, dans lequel des indications d'effets souhaités supplémentaires sont fournies au décodeur par via l'interface, dans lequel les métadonnées incluent une pluralité d'ensembles DRC configurés pour fournir l'effet de compensation de sonie dynamique, et dans lequel la sélection dépend des effets souhaités supplémentaires.

11. Procédé selon la revendication 9 ou 10, dans lequel l'indication indiquant qu'un effet de compensation de sonie dynamique est souhaité est fournie via un paramètre drcEffectTypeRequest d'une charge utile dynamicRangeControllerlnterface.

12. Décodeur pour le traitement de données audio en vue de leur lecture, dans lequel le décodeur comprend un ou plusieurs processeurs et une mémoire non transitoire configurés pour réaliser le procédé selon l'une quelconque des revendications 1 à 11.

13. Produit de programme informatique comprenant un support de stockage lisible par ordinateur avec des instructions adaptées pour amener un dispositif à réaliser le procédé selon l'une quelconque des revendications 1 à 11.

14. Support de stockage lisible par ordinateur stockant le produit de programme informatique selon la revendication 13.
